# EUROPEAN PATENT APPLICATION

(11) **EP 3 211 659 A1**
(43) Date of publication of application: **30.08.2017**
(21) Application number: 17165792.7
(22) Date of filing: 22.12.2003
(51) Int. Cl.: H01L 21/02, C30B 29/40, C30B 7/10, H01L 29/66, H01L 29/732, H01L 29/737, H01L 29/778, H01L 33/32, B01J 3/06, H01L 29/20

(54) **GALLIUM NITRIDE CRYSTAL**

(30) Priority: 27.12.2002 US 329981; 27.12.2002 US 329982
(62) Divisional of application: 03800171.5
(71) Applicant: Soraa Inc., Fremont, CA 94555 (US)
(72) Inventor: D'Evelyn, Mark Philip, Niskayuna, NY 12309 (US); Park, Dong-Sil, Niskayuna, NY 12309 (US); Narang, Kristi Jean, Vorheesville, NY 12186 (US); LeBoeuf, Steven Francis, Schenectady, NY 12309 (US); Hong, Huicong, Niskayuna, NY 12309 (US); Sandvik, Peter Micah, Guilderland, NY 12084 (US); Rowland, Larry Burton, Scotia, NY 12302 (US)
(74) Representative: Zimmermann & Partner Patentanwälte mbB

(57) **Abstract**

A device which includes at least one epitaxial semiconductor layer disposed on a single crystal substrate comprised of gallium nitride having a dislocation density less than about 10⁴ per cm², substantially no tilt boundaries, and an oxygen impurity level of less than 10¹⁹ cm⁻³.

The electronic device may be in the form of lighting applications such as light emitting diode (LED) and laser diode (LD) applications and devices such as GaN based transistors, rectifiers, thyristors, and cascode switches, and the like. Also provided is a method of forming a single crystal substrate comprised of gallium nitride having a dislocation density less than about 10⁴ per cm², substantially no tilt boundaries, and an oxygen impurity level of less than 10¹⁹ cm⁻³, and homoepitaxially forming at least one semiconductor layer on the substrate and an electronic device.

## Description

### CROSS-REFERENCE TO OTHER APPLICATIONS

This application claims priority to U.S. Patent Application No. 10/329981, with a filing date of December 27, 2002 and U.S. Patent Application No. 10/329982, also with a filing date of December 27, 2002.

### FIELD OF THE INVENTION

The present invention relates to a high quality gallium nitride single crystal, a method of making the same, homoepitaxial gallium nitride (GaN) based devices, e.g., lighting applications such as more specifically to light emitting diode (LED) and laser diode (LD) applications and devices such as GaN based photodetectors, transistors, rectifiers, thyristors, and cascode switches, and methods for making the same.

### BACKGROUND OF THE INVENTION

During the past decade there has been tremendous interest in gallium nitride (GaN) based electronic devices and optoelectronic devices, including light emitting diodes (LED), laser diodes (LD), and various types of transistors. However, the quality and reliability of these devices is compromised by very high defect levels, particularly threading dislocations in semiconductor layers of the devices. These dislocations can arise from lattice mismatch of GaN based semiconductor layers to a non-GaN substrate such as sapphire or silicon carbide. Additional defects can arise from thermal expansion mismatch, impurities, and tilt boundaries, depending on the details of the growth method of the layers.

Gallium nitride (GaN) based electronic devices offer superior high voltage, high power, high temperature, and high frequency operation, as compared to analogous devices fabricated on silicon, gallium arsenide (GaAs) or indium phosphide (InP) substrates due to GaN's wide bandgap, high breakdown field, and high saturation velocity. A variety of types of GaN-based devices are of interest for microwave power amplifier and low-noise amplifier applications, including metal semiconductor field effect transistors (MESFETs), metal oxide field effect transistors (MOSFETs), metal insulator field effect transistors (MISFETs), bipolar junction transistors (BJTs), heterojunction bipolar transistors (HBTs) and high electron mobility transistors (HEMTs), also known as heterojunction field-effect transistors (HFETs), modulation-doped field effect transistors (MODFETs), two-dimensional electron gas field effect transistors (TEGFETs), or selectively-doped heterostructure transistors (SDHTs), which take advantage of the bandgap engineering possible with III-V heterojunctions to provide considerably higher electron mobilities than analogous MESFETs. Additional GaN-based devices are of interest for power electronic applications, including thyristors, Schottky rectifiers, p-i-n diodes, power vertical MOSFETs, power vertical junction field effect transistors (JFETs), and cascode switches, which take advantage of GaN's wide bandgap, high breakdown field, high thermal conductivity, and high electron mobility.

Heteroepitaxial GaN-based electronic and optoelectronic devices have demonstrated performance levels that are satisfactory for some applications, but do not have the requisite level of reliability. Typically, GaN-based devices have employed heteroepitaxial growth of GaN and AlGaN on sapphire or SiC substrates. A thin low-temperature nucleation layer, AlN or GaN, also referred to as a buffer layer, is typically used in order to accommodate the lattice mismatch between GaN and the substrate and maintain an epitaxial relationship to the substrate.

The use of sapphire substrates with a low-temperature nucleation layer has a number of important limitations for manufacture of LEDs and other devices. Sapphire is an electrical insulator, forcing electrical contacts to be made above and to the side of the device structure, rather than above and below (a so-called vertical device structure), wasting space on the wafer. In addition, sapphire has a rather poor thermal conductivity, limiting heat dissipation. Sapphire has a large (16%) lattice mismatch with respect to GaN, so that even with the use of buffer layers a very high level of threading dislocations (10⁷-10¹¹ cm⁻²) is generated within the device structure. The excess strain in the device structure, due to thermal expansion mismatch, results in degraded performance, device yield, and reliability. Specifically, these dislocations can act as non-radiative recombination centers and may limit performance in certain applications, such as, for example, reducing emission efficiency in near-ultraviolet and high power LEDs and LDs and reducing the lifetime in LDs and other high-power devices. Deposition of the nucleation layer also adds cost and complexity to the process. Sapphire also has a large (45%) mismatch in the thermal expansion coefficient with respect to GaN, which generates stresses in device structures upon cooldown from the processing temperature and limits the maximum size of wafers and thickness of epitaxial layers that can be used without forming cracks. Facets must be prepared at the ends of laser diode structures in order to define the laser cavity, and the difficulty in cleaving c-axis-oriented sapphire makes facet preparation more expensive.

The use of SiC substrates alleviates some of these limitations but introduces other problems. The lattice mismatch to GaN is smaller than that of sapphire, but very high defect concentrations are still generated, and the use of low-temperature nucleation layers is still needed. SiC is also much more expensive than sapphire. Lower cost SiC is typically partially opaque, decreasing the efficiency of the LED device because light emitted from the active region toward the substrate would be absorbed rather than transmitted. Since some applications of LEDs involve emission of ultraviolet light; this light could be absorbed by even a high-quality, transparent SiC substrate because the bandgap is less than that of sapphire or GaN.

The use of gallium nitride has been limited in photodetector applications because of the quality and manufacturing issues discussed above. A high-performance photodetector could be used, for example, to control the temperature in the combustor of power-generation turbines or in aircraft engines, allowing continuous, real-time optimization of combustion conditions and improved energy efficiency and reliability. Photodetectors could also be used in a wide variety of sensor applications, both civilian and military. While current heteroepitaxial technology allows for production of commercially viable GaN-based LEDs and LDs, the photodetectors that can be produced with current technology are marginal in performance because of very high defect levels.

The presence of defects has a deleterious effect on epitaxially-grown layers, compromising electronic device performance and requiring complex, tedious fabrication steps to reduce the concentration and/or impact of the defects. A high-quality GaN substrate would reduce these problems. The substrate could be made electrically conductive as well as semi-insulating, so vertical LED or LD structures could be fabricated. The thermal conductivity of pure GaN is five times that of sapphire, improving heat dissipation, enabling higher power levels, and improving lifetime. Also, there would be no thermal expansion mismatch, resulting in ease of scalability to larger substrates, which would reduce cost. The concentration of threading dislocations would be reduced by 3-10 orders of magnitude, which would reduce leakage currents, improve device yields, and the consistency of I-V characteristics, increase device lifetimes, particularly at high power levels, and may also improve emission efficiency and resistance to static discharge. Furthermore, GaN is much easier to cleave than sapphire, and LD facets can be prepared by simple cleavage rather than by reactive ion etching, further reducing costs. Growth of homoepitaxial photodetectors on high-quality GaN substrates would offer improved sensitivity, increased efficiency, reduced leakage (dark) current, and increased breakdown field. Other potential benefits of homoepitaxial photodetectors include increased temperature of operation, better reliability, better device uniformity, improved backside contact capability, higher manufacturing yield, longer lifetime, enhanced wafer utilization, improved wavelength selectivity, and better manufacturability.

While a substantial number of growth methods for gallium nitride crystals have been proposed, the methods to date still merit improvement.

U.S. Patent Nos. 5,637,531 and 6,273,948 disclose methods for growing gallium nitride crystals at high pressure and high temperature, using liquid gallium and gallium-based alloys as a solvent and a high pressure of nitrogen above the melt to maintain GaN as a thermodynamically-stable phase. The process is capable of growing electrically-conductive GaN crystals with a dislocation density of about 10³ - 10⁵ cm⁻² or, alternatively, semi-insulating GaN crystals with a dislocation density of about 10-10⁴ cm⁻², as described by Porowski, "Near defect-free GaN substrates" [MRS Internet J. Nitride Semicond. Research 4S1, G1.3 (1999)].

The conductive crystals, however, have a high concentration of n-type defects, on the order of 5 × 10¹⁹ cm⁻³. These defects are believed to comprise oxygen impurities and nitrogen vacancies. As a consequence, the crystals are relatively opaque, with an absorption coefficient of about 200 cm⁻¹ at wavelengths in the visible portion of the spectrum. As a consequence, up to half the light emitted by a light emitting diode (LED) fabricated on such a crystal is absorbed by the substrate. This constitutes a large disadvantage compared to conventional heteroepitaxial LEDs fabricated on sapphire or transparent SiC substrates. Further, the high concentration of n-type defects in nominally undoped crystals grown in molten Ga causes the lattice constant to increase by about 0.01-0.02%, which generates strain in undoped epitaxial GaN layers deposited thereupon. Additionally, the undoped GaN substrates formed by this method have a rather limited carrier mobility, about 30-90 cm²/V-s, which may be limiting in high-power devices.

The transparency and dislocation density of GaN crystals grown in liquid Ga may be improved by the addition of Mg or Be to the growth medium, but the crystals so produced are semi-insulating, with a resistivity above about 10⁵ Ω-cm at room temperature. Such crystals are not appropriate for vertical devices in which one electrical contact is made to the substrate itself. These substrates have several additional disadvantages, including: (i) a high concentration of Mg and O atoms, approximately 10¹⁹ cm⁻³ each [J. I. Pankove et al., Appl. Phys. Lett. 74, 416 (1999)], which could potentially diffuse into device structures during high temperature processing; and (ii) relatively poor thermal conductivity. Dopants may diffuse into the undoped GaN buffer layer in a high electron mobility transistor (HEMT), for example, in which transport by the two-dimensional electron gas is designed to occur, degrading carrier mobility. In addition, the presence of the point defects scatters phonons in the bulk GaN substrate and degrades thermal conductivity, which is detrimental to achieving theoretical performance levels in GaN-based HEMTs.

The Porowski et al. method discloses yielding a number of platelet crystals, with a diameter of about 10 mm and a thickness of 0.1-0.2 mm; growth stops at this point for reasons that are still not well understood. The largest crystal grown to date by this method is about 20 mm in diameter. Because the process yields platelets rather than thick boules (meaning GaN boules and wafers with diameters of at least 50 mm), the economies of scale associated with conventional wafering technology (slicing, polishing) cannot be achieved and the substrates will remain extremely expensive.

The most mature technology for growth of pseudo-bulk or bulk GaN is hydride/halide vapor phase epitaxy, also known as HVPE. In the most-widely applied approach, HCl reacts with liquid Ga to form vapor-phase GaCl, which is transported to a substrate where it reacts with injected NH₃ to form GaN. Typically the deposition is performed on a non-GaN substrate such as sapphire, silicon, gallium arsenide, or LiGaO₂. The dislocation density in HVPE-grown films is initially quite high, on the order of 10¹⁰ cm⁻² as is typical for heteroepitaxy of GaN, but drops to a value of about 10⁷ cm⁻² after a thickness of 100-300 µm of GaN has been grown. For example, Vaudo et al. [US 6,596,079] teach a method for fabricating GaN wafers or boules with a dislocation density below 10⁷ cm⁻².

HVPE may be capable of reducing defect levels further in thicker films, but values below 10⁴ cm⁻² dislocation density over an entire wafer have not been reported. Edge dislocations, which normally comprise a significant fraction of the threading dislocations present in heteroepitaxially-grown GaN, are expected to persist indefinitely upon growth of an arbitrarily-thick GaN film. Even if GaN wafers are sliced from a thick HVPE-grown boule and used as a seed for additional growth, the edge dislocations are expected to persist indefinitely. Vaudo et al. [Phys. Stat. Solidi(a) 194, 494 (2002)] reported a dislocation density below 10⁴ cm⁻² within a grain of a thick HVPE film; however, the dislocation density between grains, most likely comprising predominantly edge dislocations, is expected to be much higher. In addition, strain is present in HVPE wafers due to the thermal expansion mismatch between substrate and film. This strain produces bowing upon cool down of the substrate and film after growth, which remains even after removal of the original substrate.

For reasons that are not yet understood, in thick HVPE GaN neither absorption nor emission of light at room temperature occurs with a threshold at the band edge. In transmission spectroscopy, HVPE GaN absorbs with a cutoff near 370 nm, significantly shifted from the expected cutoff near 366 nm. Similarly, the photoluminescence peak at room temperature occurs at 3.35 eV, at significantly lower energy than expected. This behavior will compromise the performance of light emitting devices operating in the ultraviolet, as some of the light will be absorbed by the substrate rather than being emitted. The shifted photoluminescence peak indicates the presence of defect states that may compromise device performance.

Other widely-applied methods for growth of large area, low-dislocation-density GaN are variously referred to as epitaxial lateral overgrowth (ELO or ELOG), lateral epitaxial overgrowth (LEO), selective area growth (SAG), dislocation elimination by epitaxial growth with inverse pyramidal pits (DEEP), or the like. U.S. Patent No. 6,294,440 discloses a homoepitaxial light-emitting laser diode on such a substrate. In variations of this method, heteroepitaxial GaN growth is initiated in a one- or two-dimensional array of locations on a substrate, where the locations are separated by a mask, trenches, or the like. The period or pitch of the growth locations is between 3 and 100 µm, typically between about 10 and 20 µm. The individual GaN crystallites grow and then coalesce. Epitaxial growth is then continued on top of the coalesced GaN material to produce a thick film or "ingot." Typically, the thick GaN layer formed on the coalesced GaN material is deposited by HVPE.

The ELO process is capable of large reductions in the concentration of dislocations, particularly in the regions above the mask, typically to levels of about 10⁵ - 10⁷ cm⁻². However, light emitting devices fabricated on ELO substrates typically have a surface area of at least about 10⁴ µm² (10⁻⁴ cm²) and still contain a substantial number of threading dislocations. In addition, an ELO GaN substrate is not a true single crystal although a number of authors do refer to ELO structures as single crystals. Each individual GaN crystallite constitutes a grain, and there is typically a low-angle grain boundary or a tilt boundary at the points where the grains coalesce. The low-angle or tilt boundaries are manifested as an array of edge dislocations, and generate lateral strain within the GaN. The magnitude of the crystallographic tilting depends on the details of the masking and growth conditions, but there is generally at least a low level of tilting associated with grain coalescence. Much or most of the crystallographic tilting forms directly during growth, rather than simply being a consequence of thermal expansion mismatch. The separation between the tilt boundaries is equal to the period or pitch of the original mask, or typically about 10-20 µm. The consequence is that devices formed on such substrates will also have tilt boundaries running through them if the devices have lateral dimensions larger than about 100 µm, and particularly if they have lateral dimensions larger than about 300 µm, and even more so if they have lateral dimensions larger than about 2000 µm. The tilt boundaries in substrates or devices can be detected by a range of analytical techniques, including transmission electronic microscopy, x-ray diffraction, and x-ray topography.

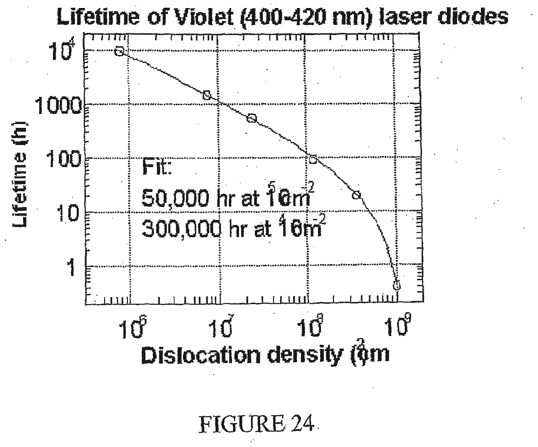

Residual stress or strain in homoepitaxial GaN-based devices resulting, for example, from the presence of tilt boundaries, may accelerate the degradation of LDs, high-power LEDs, high power transistors, or other devices. Similarly, dislocations associated with tilt boundaries may reduce the lifetime of high-power light emitting diodes, laser diodes, and power electronic devices. An example of such behavior, showing the dependence of laser diode lifetime on dislocation density, is shown in Figure 24. Degradation of device lifetimes by dislocations may result from facilitating impurity diffusion into the active layer or from facile generation of new dislocations. Dislocations may act as non-radiative recombination centers, degrading the light emission efficiency of light emitting diodes and laser diodes. Dislocations may also increase reverse-bias current leakage, degrading the performance of diodes, transistors, and photodetectors. Clearly, the presence of even a single dislocation within a GaN-based device can degrade its performance and/or lifetime.

The tilt-grain-boundary structure and lateral strain persists throughout an entire ingot and therefore into each substrate sliced from this ingot. In other words, no substrate sliced from such an ingot will be a true single crystal, free of tilt boundaries and lateral strain. In addition, the GaN substrate is likely to suffer from the same deficiencies in UV absorption and photoluminescence at room temperature as "standard" HVPE GaN.

Other methods for crystal growth of GaN involve the use of supercritical ammonia as a solvent. Growth of very small GaN crystals in supercritical ammonia have been disclosed, notably by Kolis et al. in: 1) "Materials Chemistry and Bulk Crystal Growth of Group III Nitrides in Supercritical Ammonia", Mater. Res. Soc. Symp. Proc. 495, 367 (1998)]; 2) "Crystal Growth of Gallium Nitride in Supercritical Ammonia", J. Cryst. Growth 222, 431 (2001); 3) "Synchrotron white beam topography characterization of physical vapor transport grown AlN and ammonothermal GaN", J. Cryst. Growth 246, 271 (2002); and Dwilinski et al. in: 1) "AMMONO Method of GaN and AlN Production", Diamond Relat. Mater. 7, 1348 (1998); 2) "AMMONO Method of BN, AlN, and GaN Synthesis and Crystal Growth", MRS Internet J. Nitride Semiconductor Res. 3, article 25 (1997); 3) "On GaN Crystallization by Ammonothermal Method" Acta Phys. Pol. A 90, 763 (1996); and 4) "GaN Synthesis by Ammonothermal Method" Acta Phys. Polonica A 88, 833 (1995)].

These prior art methods generally use ammonobasic chemistry, with the addition of a mineralizer chosen from at least one of A, ANH₂, or AX, where A is an alkali atom and X is a halide. In the presence of NH₃, alkali atoms A will generally react to form ANH₂ + ½ H₂ and are therefore also considered basic. However, only small crystals or mm-sized crystals of rather poor quality, with a dislocation density above about 10⁶ cm⁻², have been reported to date. In addition, these authors do not disclose the use of temperature gradient profiles to optimize growth on seeds.

Even more recently, Dwilinski et al., in US Patent Publication Nos. 2002/0189531A1 and 2002/0192507A1, and PCT Patent Application WO No. 03/035945, disclose an improved ammonobasic method for growing GaN involving the use of compound temperature gradient profiles. These Dwilinski et al. references disclose a dislocation density in the range of 10⁴ - 10⁸ cm⁻² or less. In the single example presented, a dislocation density of 6 × 10⁴ cm⁻² is reported in a layer about 200-300 µm thick above an HVPE seed. The present inventors speculate that this value underestimates the actual dislocation density, based on the modest thickness of the grown layer and typical dislocation densities in HVPE seeds (ca. 10⁷ cm⁻²). Furthermore, there is no teaching in Dwilinski et al. on the elimination of tilt boundaries from GaN crystals. Tilt boundaries are expected in Dwilinski et al. GaN crystals due to use of HVPE seeds, which inevitably contain tilt boundaries. Furthermore, Dwilinski et al, teach the addition of gallium or alkali metal to the reactor. Such additions will produce hydrogen by chemical reaction with ammonia, which is undesirable because hydrogen tends to embrittle the walls of the pressure vessel and is not an effective solvent for GaN. The Dwilinski et al. references teach the use of pressures as high as 10 kbar but offer no effective way of achieving such pressure since the references teach the use of autoclaves as pressure vessels -- autoclaves can safely reach a maximum pressure of only 5 kbar. Lastly, Dwilinski et al. report very small rates, ca. 0.2-3 µm/hr, hardly larger than those achieved by conventional MOCVD and thus raising serious questions about the economic viability of the method.

French patent FR 2,796,657 to Demazeau et al. discloses a method for GaN growth in supercritical ammonia or hydrazine at pressures of 0.05-20 kbar, temperatures of 100-600 °C, and a temperature gradient of 10-100 °C, using a Tuttle-type cold-seal pressure vessel well known in the art and with a limited maximum pressure of 5-6 kbar. Standard pressure vessels are limited to a pressure of about 5-6 kbar when working with NH₃, as discussed by Jacobs and Schmidt in "High Pressure Ammonolysis in Solid-State Chemistry", Curr. Topics Mater. Sci. 8, ed. by E Kaldis (North-Holland, 1982)], limiting the maximum temperature, reaction rate, and, in all likelihood, crystalline quality. Therefore, Demazeau discloses no method capable of reaching the higher pressure range, and does not demonstrate GaN crystals larger than 1 mm in size.

US 6,398,867 to D'Evelyn et al. discloses a method for temperature gradient recrystallization of GaN in a supercritical fluid at a pressure greater than 5 kbar, a temperature greater than 550 °C, with a temperature gradient of 5-300 °C. There is no disclosure of the use of temperature gradient profiles to optimize growth on seeds, nor the demonstration of dislocation densities below 10⁴ cm⁻².

Gallium nitride grown by all known methods contains native defects that may degrade the properties of the crystal and of devices grown thereupon. One commonly occurring native defect is the Ga vacancy which, in n-type GaN, acts as a deep, triple acceptor that compensates donors. In principle, hydrogen can bind to gallium vacancies, capping the dangling bond on 1-4 surrounding N atoms to form N-H bonds, denoted V_{Ga}H, V_{Ga}H₂, V_{Ga}H₃, and V_{Ga}H₄. N-H bonds associated with Ga vacancies are predicted [C. Van de Walle, Phys. Rev. B 56, R10020 (1997)] to have vibration frequencies between 3100 and 3500 cm⁻¹ and to be quite stable. However, known GaN crystal growth methods do not provide a means for passivating Ga vacancies by hydrogenation. For example, infrared transmission spectroscopy on 300-400 µm thick GaN samples grown by HVPE revealed weak absorption features near 2850 and 2915 cm⁻¹ associated with another defect, but no absorption features between 3100 and 3500 cm⁻¹ that could be assigned to hydrogenated Ga vacancies were observed.

Some limited work has previously been carried out on forming homoepitaxial LED or LD devices on GaN substrates. Writing in the Journal of Crystal Growth, Pelzmann, et al. reported that homoepitaxial homojunction GaN LED devices demonstrated a doubling of the emission intensity relative to the analogous device on a sapphire substrate. However, homojunction GaN LEDs have much lower emission intensities than InGaN/GaN heterojunction LEDs, as is well known in the art. Therefore, the devices demonstrated by Pelzmann, et al. do not offer any performance advantages relative to conventional heteroepitaxial LEDs.

Kamp et al. have developed a method for the formation of GaN crystals with homoepitaxial LED growth thereon. This work, reported in the MRS Internet Journal of Nitride Semiconductor Research, focuses on the application of chemically assisted ion beam etching as a method for polishing the GaN crystal prior to LED formation. Grzegory et al. and Prystawko et al. have reported the fabrication of a pulsed-operation blue LD on a bulk GaN substrate. The homoepitaxial GaN-based LEDs described by Kamp et al. and the LDs described by Grzegory et al. and by Prystawko et al. suffer from a number of important limitations. For example, the relative opacity of these substrates, with an absorption coefficient of about 200 cm⁻¹ at wavelengths between 700 nm (red) and 465 nm (blue) in the visible portion of the spectrum, causes up to half the light emitted by the LED to be absorbed by the substrate. This constitutes a large disadvantage compared to conventional heteroepitaxial LEDs fabricated on sapphire or transparent SiC substrates. In addition, the substrates employed by Kamp et al., Grzegory et al., and by Prystawko et al. have a dislocation density of approximately 10³ to 10⁵ cm⁻². This value is lower than the corresponding values in heteroepitaxial LEDs of approximately 10⁷ to 10¹⁰ cm⁻² but will still result in dislocations being present in large-area devices. Further, the high concentration of n-type defects in undoped crystals grown in molten Ga causes the lattice constant to increase by about 0.01-0.02%, which generates strain in undoped epitaxial GaN layers deposited thereupon. Additionally, the undoped GaN substrates employed by Kamp et al., Grzegory et al., and by Prystawko et al. have a rather limited carrier mobility, about 30-90 cm²/V-s, which may be limiting in high-power devices.

U.S. Patent Nos. 5,770,887 and 5,810,925 teach the growth of double-heterostructure LEDs on GaN pseudo-substrates. These pseudo-substrates comprise GaN/ZnO multilayers rather than GaN single crystals. The ZnO served as buffer layers throughout the crystal growth process, and the process therefore required extra steps for the formation and later removal of the ZnO layers. The reference does not disclose dislocation densities that are achievable by this method.

Homoepitaxial LEDs, laser diodes, and photodetectors on GaN substrates grown by HVPE, either without or with ELO techniques, have been disclosed by Flynn et al. [US 6,447,604], by Yasan et al. [Appl. Phys. Lett. 81, 2151 (2002)] and by Tsuda et al. [US 6,294,440]. However, these devices suffer from the shortcomings discussed above, including dislocation densities of approximately 10⁵-10⁸ cm⁻² and the presence of tilt boundaries.

With respect to homoepitaxial GaN-based electronic device designs, at least one design, specifically, a HEMT, has been reported to date. Khan et al. [Appl. Phys. Lett. 76, 3807 (2000)] disclose the fabrication of an AlGaN/GaN HEMT on a bulk GaN substrate that was grown in a liquid Mg/Ga alloy at temperatures of 1300-1500 °C and N₂ pressures of 15-20 kbar. These substrates, however, have several disadvantages including: (i) a high concentration of Mg and O atoms, approximately 10¹⁹ cm⁻³ each, which could potentially diffuse into device structures during high temperature processing; and (ii) relatively poor thermal conductivity. In addition, the resistivity of the substrate (∼ 10⁵ Ω-cm) was undesirably low for a HEMT, and could degrade the frequency response of the device and also create residual charging in the GaN buffer layer and DC-RF drain current dispersion. In fact, the homoepitaxial HEMT reported by Khan et al. actually had a slightly inferior performance to a similar device fabricated on a SiC substrate.

The present inventors have developed a method for forming a high quality GaN substrate, free of tilt boundaries and with a dislocation density less than 10⁴ cm⁻², on which to form homoepitaxial LED, LD, photodetector, or electronic devices, to overcome the above-mentioned problems. In one embodiment of the invention, The present inventors have surprisingly discovered the use of temperature gradient profiles to optimize growth on seeds, for GaN crystals that are larger than 1mm in size and with a dislocation density less than 10⁴ cm⁻².

### SUMMARY OF THE INVENTION

In accordance with one aspect of the present invention, there is provided a GaN single crystal at least about 2 millimeters in diameter, with a dislocation density less than about 10⁴ cm⁻¹, and having substantially no tilt boundaries and with an oxygen impurity level below 10¹⁹ cm⁻³.

In accordance with another aspect of the present invention, there is provided a GaN single crystal at least about 2 millimeters in diameter, and having substantially no tilt boundaries and with an oxygen impurity level below 10¹⁹ cm⁻³, wherein the single crystal has a photoluminescence spectrum which peaks at a photon energy of between about 3.38 and about 3.41 eV at a crystal temperature of 300K. In one embodiment, the crystal contains hydrogen in a form that results in an infrared absorption peak near 3175 cm⁻¹, with an absorbance per unit thickness greater than about 0.01 cm⁻¹.

In accordance with one aspect of the present invention, there is provided a method comprising the steps of (a) providing a nucleation center in a first region of a chamber; (b) providing a GaN source material in a second region of the chamber; (c) providing a GaN solvent in the chamber; (d) pressurizing the chamber; (e) generating and holding a first temperature distribution such that the solvent is supersaturated in the first region of the chamber and such that there is a first temperature gradient between the nucleation center and the GaN source material such that GaN crystal grows on the nucleation center and (f) generating a second temperature distribution in the chamber such that the solvent is supersaturated in the first region of the chamber and such that there is a second temperature gradient between the nucleation center and the GaN source material such that GaN crystal grows on the nucleation center, wherein the second temperature gradient is larger in magnitude than the first temperature gradient and the crystal growth rate is greater for the second temperature distribution than for the first temperature distribution.

In accordance with another aspect of the present invention, there is provided a method of forming a GaN single crystal. The method comprises the steps of (a) providing a nucleation center in a first region of a chamber having a first end; (b) providing a GaN source material in a second region of the chamber having a second end; (c) providing a GaN solvent in the chamber; (d) pressurizing the chamber to a pressure of between 5 and 80 kbar; (e) generating and holding a first temperature distribution having an average temperature between about 550 °C and about 1200 °C such that the solvent is supersaturated in the first region of the chamber and such that there is a first temperature gradient between the first end and the second end such that GaN crystal grows on the nucleation center; and (f) generating a second temperature distribution in the chamber having an average temperature between about 550 °C and about 1200 °C such that the solvent is supersaturated in the first region of the chamber and such that there is a second temperature gradient between the first end and the second end such that GaN crystal grows on the nucleation center, wherein the second temperature gradient is larger in magnitude than the first temperature gradient and the crystal growth rate is greater for the second temperature distribution than for the first temperature distribution.

In accordance with another aspect of the present invention, there is provided a method of forming a GaN single crystal. The method comprises (a) providing a nucleation center in a first region of a chamber having a first end; (b) providing a GaN source material in a second region of the chamber having a second end; (c) providing a GaN solvent in the chamber; (d) pressurizing the chamber; (e) generating and holding a first temperature distribution such that there is a first temperature gradient between the first end and the second end; and (f) generating a second temperature distribution in the chamber such that the solvent is supersaturated in the first region of the chamber and such that there is a second temperature gradient between the first end and the second end such that GaN crystal grows on the nucleation center, wherein the first temperature gradient is zero or opposite in sign from the second temperature gradient.

In accordance with one aspect of the present invention, there is provided a homoepitaxial gallium nitride based electronic device. The device comprises at least one epitaxial semiconductor layer disposed on a single crystal substrate comprised of gallium nitride, the substrate having a dislocation density less than about 10⁴ per cm² and having no tilt boundaries, wherein the at least one epitaxial semiconductor layer is included in the electronic device which comprises one of a transistor, rectifier, thyristor, and cascode switch.

In another aspect of the invention, there is provided a method of forming an electronic device comprising: providing a single crystal substrate comprised of gallium nitride having a dislocation density less than about 10⁴ per cm² and having substantially no tilt boundaries, and with an oxygen impurity level below 10¹⁹ cm⁻³; homoepitaxially forming at least one semiconductor layer on the substrate, wherein the electronic device is one of a transistor, rectifier, thyristor, and cascode switch.

In another exemplary embodiment of the present invention, a light emitting device ("LED") is provided. The LED is comprised of a light emitting semiconductor active region disposed on a substrate comprised of GaN having a dislocation density less than 10⁴ per cm² and having substantially no tilt boundaries, and with an oxygen impurity level below 10¹⁹ cm⁻³.

In a further embodiment of the present invention, a method for the preparation of a light emitting device comprising disposing a group III semiconductor active region on a substrate comprised of GaN in the absence of low-temperature buffer layers is described.

In yet another embodiment of the present invention, a homoepitaxial light emitting diode is provided. The homoepitaxial light emitting diode is comprised of a n-electrode, a n-GaN substrate; optionally at least one n-GaN or n-AlᵤInᵥGa₁₋ᵤ₋ᵥN cladding layer, an Al_{w}InₓGa_{1-w-x}N active layer, at least one p-Al_{y}In_{z}Ga_{1-y-z}N cladding layer or p-GaN cladding layer; and a p-electrode, wherein 0 ≤ *u,v,w,x,y,z* ≤ 1, 0 ≤ *u*+*v*, *w*+*x, y*+*z* ≤ 1, wherein the band gap of the active layer is less than the band gap of the cladding layers.

In an additional exemplary embodiment of the present invention, a homoepitaxial laser diode is comprised of a n-electrode, a n-GaN substrate, at least one n-GaN or n-AlₐIn_{b}Ga_{1-a-b}N cladding layer, optionally, at least one n-Al_{c}In_{d}Ga_{1-c-d}N optical guiding layer, a AlₑIn_{f}Ga_{1-e-f}N / Al_{g}InₕGa_{1-g-h}N multiple quantum well, optionally, a pAlᵢInⱼGa₁₋ᵢ₋ⱼN blocking layer, optionally, as least one p-AlₖInₗGa₁₋ₖ₋ₗN optical guilding layer, at least one p-AlₘInₙGa₁₋ₘ₋ₙₗN cladding layer, optionally, a p-AlₒInₚGa₁₋ₒ₋ₚN contact layer, and a p-electrode, wherein 0 ≤ *a, b, c, d, e, f, g, h, i, j, k, l, m, n, o, p* ≤ 1; 0 ≤ *a*+*b, c*+*d, e*+*f, g*+*h, i*+*j, k*+*l, m*+*n*, *o*+*p* ≤ 1, wherein the band gap of the multiple quantum well active layer is less than that of the optical guiding layers, which are in turn less than that of the cladding layers, which are less than that of the p-type blocking layer. Sidewalls and parallel facets are then provided in directions perpendicular to the deposited layers.

In another exemplary embodiment of the present invention, a homoepitaxial photodetector is provided. The photodetector of the present invention includes a gallium nitride substrate having a dislocation density less than 10⁴ per cm² and having no tilt boundaries, at least one active layer disposed on the substrate, and a conductive contact structure affixed to the active layer and, in some embodiments, the substrate. In one embodiment of the invention, the photodetector has a metal-semiconductor-metal (MSM) type structure, in which an insulating active layer is deposited on the gallium nitride substrate, and the conductive contact structure is a patterned array of interdigitated Schottky-type (i.e., rectifying) metallic contacts connected to the semi-insulating active layer.

Another embodiment of the invention is a photodetector having a P-i-N structure. The photodetector includes either an n-doped gallium nitride substrate or an n-doped active layer deposited on the substrate, an insulating active layer, and a p-doped active layer. In this embodiment, the conductive contact structure comprises at least one ohmic-type contact connected to the p-type active layer and an ohmic contact connected to the substrate.

The photodetector of the present invention also encompasses a third embodiment, which is a Schottky-barrier structure, in which an insulating active layer is deposited on the gallium nitride substrate, and the conductive contact structure comprises at least one Schottky-type contact connected to the insulating active layer and an ohmic contact connected to the substrate.

An additional aspect of the present invention is to provide a photodetector. The photodetector comprises: a gallium nitride substrate, the gallium nitride substrate comprising a single crystal gallium nitride wafer and having a dislocation density of less than about 10⁴cm⁻²; at least one active layer disposed on the gallium nitride substrate, the active layer comprising Ga_{1-*x*-*y*}Al*ₓ*In*_{y}*N, wherein 0 ≤ *x, y* ≤ 1, and 0 ≤ *x* + *y* ≤ 1; and at least one conductive contact structure affixed to at least one of the gallium nitride substrate and the active layer.

An additional aspect of the invention is to provide a method of making a photodetector, the photodetector comprising a gallium nitride substrate having a dislocation density less than 10⁴ per cm², having substantially no tilt boundaries, and with an oxygen impurity level below 10¹⁹ cm⁻³, at least one active layer disposed on the gallium nitride substrate, and at least one conductive contact structure affixed to at least one of the gallium nitride substrate and the active layer. The method comprises the steps of: providing a gallium nitride substrate; depositing at least one active layer on the gallium nitride substrate; and affixing a conductive connecting structure to at least one of the at least one active layer and the gallium nitride substrate.

These and other aspects, advantages, and salient features of the invention will become apparent from the following detailed description, the accompanying drawings, and the appended claims.

### BRIEF DESCRIPTION OF THE DRAWINGS

Figure 1 is a schematic illustration of a HEMT device according to a preferred embodiment of the invention.
Figure 2 is a schematic illustration of a HEMT device according to another preferred embodiment of the invention.
Figure 3 is a schematic illustration of a HEMT device according to another preferred embodiment of the invention.
Figure 4 is a schematic illustration of a MESFET device according to another preferred embodiment of the invention.
Figure 5 is a schematic illustration of a MOSFET or MISFET device according to another preferred embodiment of the invention.
Figure 6 is a schematic illustration of a HBT device according to another preferred embodiment of the invention.
Figure 7 is a schematic illustration of a BJT device according to another preferred embodiment of the invention.
Figure 8 is a schematic illustration of a Schottky rectifier device according to another preferred embodiment of the invention.
Figure 9 is a schematic illustration of a p-i-n rectifier device according to another preferred embodiment of the invention.
Figure 10 is a schematic illustration of a thyristor device according to another preferred embodiment of the invention.
Figure 11 is a schematic illustration of a UMOSFET/UMISFET device according to another preferred embodiment of the invention.
Figure 12 is a schematic illustration of a DMOSFET/DMISFET device according to another preferred embodiment of the invention.
Figure 13 is a schematic illustration of a power Insulated Gate Bipolar Transistor (power IGBT) device according to another preferred embodiment of the invention.
Figure 14 is a schematic illustration of a power vertical JFET device according to another preferred embodiment of the invention.
Figure 15 schematically illustrates a possible way of implementing a cascode configuration according to another preferred embodiment of the invention.
Figure 16 is a schematic illustration of an integrated approach to a cascode configuration where a low voltage GaN normally-off FET is integrated on the same substrate as a vertical JFET according to another preferred embodiment of the invention.
Figure 17 is a schematic illustrating an examples of a HEMT array according to another preferred embodiment of the invention.
Figure 18 is a detailed schematic illustration of the structure of a vertical homoepitaxial light emitting diode device representative of the present invention.
Figure 19 is a detailed schematic illustration of the structure of a lateral homoepitaxial light emitting diode device representative of the present invention.
Figure 20 is a detailed schematic illustration of the structure of a homoepitaxial laser diode device representative of the present invention.
Figure 21 is a schematic cross-sectional representation of a capsule used for making a GaN single crystal according to a preferred embodiment of the invention.
Figure 22 is a schematic cross-sectional representation of a pressure vessel used for making a GaN single crystal according to a preferred embodiment of the invention.
Figure 23 is a series of photoluminescence spectra of a GaN crystal according to a preferred embodiment of the invention.
Figure 24 shows the dependence of laser diode lifetime on dislocation density.
Figure 25 is a schematic depiction of a prior art photodetector.
Figure 26 is a schematic depiction of a photodetector in accordance with one embodiment of the instant invention.
Figure 27 is a schematic depiction of a photodetector in accordance with another embodiment of the instant invention.
Figure 28 is a schematic depiction of a photodetector in accordance with another embodiment of the instant invention.
Figure 29 is a flow chart depicting method steps in accordance with one embodiment of the instant invention.
Figure 30 is a schematic illustration of the evolution of dislocations in bulk GaN grown on a c-oriented seed crystal containing dislocations.
Figure 31 is a schematic illustration of the evolution of tilt boundaries in bulk GaN grown on a c-oriented seed crystal containing tilt boundaries.

### DETAILED DESCRIPTION OF THE INVENTION

The present inventors have found that GaN nucleates surprisingly readily in supercritical ammonia and other supercritical GaN solvents, so that recrystallization produces many small crystals rather than one large crystal. While small high quality GaN crystals could be grown by the methods known in the prior art, no high quality crystal larger than 2 mm with a dislocation density below 10⁴ cm⁻² has been grown by these methods. The present inventors have found that a method using an improved temperature profile including appropriate temperature gradients, together with an improved method for mounting seed crystals, is capable of overcoming these limitations.

The inventors have further disclosed a homoepitaxial light emitting device and a method for forming that device using the high quality GaN crystals of the invention. In one embodiment, the device is a GaN based LED or LD grown on a GaN substrate. As used herein, the LED or LD devices are referred to as homoepitaxial even though the composition (AlInGaN) and lattice constants of the active and cladding layers are not identical to those of the substrate (GaN), because the lattice constants of the active and cladding layers are typically close to those of GaN and the underlying chemistry (group III nitride) is very similar.

A homoepitaxial GaN based electronic device structure is formed by epitaxial growth of a number of GaN based semiconductor layers on a single crystal GaN substrate. Thus in this application, a homoepitaxial GaN based electronic device is an electronic device with a GaN substrate and at least one GaN based semiconductor layer formed on the substrate. The at least one GaN based semiconductor layer comprises Ga_{1-*x*-*y*}Al*ₓ*In*_{y}*N_{1-*z*-*w*}P_{z}As*_{w}*, wherein 0 ≤ *x, y, z, w* ≤ 1, 0 ≤ *x* + *y* ≤ 1, and 0 ≤ z + *w* ≤ 1. In another embodiment, the at least one GaN based semiconductor layer comprises Al*ₓ*In*_{y}*Ga_{1-*x*-*y*}N, where 0 ≤ *x* ≤ 1, 0 ≤ *y* ≤ 1, and 0 ≤ *x*+*y* ≤ 1. In addition to the GaN based semiconductors, the homoepitaxial GaN based electronic device may have other epitaxial layers which are not GaN based, such as an AlN layer or an Al*ₓ*In_{1-*x*}N layer, where 0 ≤ *x* ≤ 1. Gallium nitride - based electronic devices, such as a transistor, rectifier, or thyristor, are grown homoepitaxially directly on a high-quality single crystal gallium nitride substrate, where the substrate has a low dislocation density and a low concentration of unintentional impurities.

Substrate Preparation Process. According to embodiments of the present invention, a high quality single crystal may be synthesized, and grown from a single nucleus to a size of at least 2 mm in diameter. The single crystal may be n-type, electrically conductive, optically transparent, free of lateral strain and tilt boundaries, and with a dislocation density less than about 10⁴ cm⁻². In one embodiment, the dislocation density is less than about 10³ cm⁻². In another embodiment, the dislocation density is less than about 100 cm⁻². In one embodiment, the single crystal is p-type; in another, it is semi-insulating. In another embodiment, the single crystal is magnetic. In yet another, it is luminescent. In one embodiment, the crystal contains hydrogen in a form that results in an infrared absorption peak near 3175 cm⁻¹, with an absorbance per unit thickness greater than about 0.01 cm⁻¹. In another embodiment, the substrate contains greater than about 0.04 ppm fluorine. In another embodiment, between about 0.04 and 1 ppm fluorine. In one embodiment, the crystal is doped with at least one of H, Be, C, O, Mg, Si, Ca, Sc, Ti, V, Cr, Mn, Fe, Co, Ni, Cu, Zn, Ge, Zr, Hf, or a rare earth metal at a concentration between about 10¹⁶ cm⁻³ and about 10²¹ cm⁻³. This large high quality gallium nitride single crystal may be grown by temperature gradient recrystallization at high pressure and high temperature in a supercritical fluid solvent.

The crystal of the present invention is a true single crystal, i.e., it has substantially no tilt boundaries (also known as low-angle grain boundaries). Here, "having substantially no tilt boundaries" means that: 1) the crystal may have tilt boundaries at such an insubstantial level or with such a small tilt angle such that the tilt boundaries may not be detectable by analytical techniques known in the art such as TEM or X-ray diffraction; or 2) the crystal may include tilt boundaries that are widely separated from one another, e.g., by at least 1 mm. In one embodiment, by at least 2 mm, and in another embodiment, by at least 5 mm.

In one embodiment of one process for forming the GaN substrate, the process comprises providing a source gallium nitride, solvent, mineralizer, and, in one embodiment, at least one GaN seed crystal. The source gallium nitride may then be combined with at least one of the mineralizer and solvent to form a mixture. The gallium nitride, solvent, and mineralizer may optionally be provided individually to the capsule as separate and distinct un-combined materials. The mixture, which can comprise gallium nitride and at least one of the solvent and mineralizer, can be optionally compacted into a pill. However the compacting of the mixture need not be conducted in the gallium nitride growth process.

Supercritical fluid: Examples of solvents or supercritical fluid include but not limited to ammonia, hydrazine, methylamine, ethylenediamine, melamine, or other nitrogen-containing fluid.

Source Material. The source gallium nitride may comprise at least one of poorly-crystallized gallium nitride, well-crystallized gallium nitride, amorphous gallium nitride, polycrystalline gallium nitride, and combinations thereof. The source gallium nitride may be provided "as-is" in its raw form. Alternatively, the source gallium nitride can be compacted into a "pill" and/or sintered into a polycrystalline compact. Alternatively, the source gallium nitride can be formed *in situ.* Gallium metal may be provided, which then reacts with the ammonia solvent after sealing of the capsule and treatment at high pressure and high temperature to form source gallium nitride.

Examples of source material may comprise single crystal or polycrystalline GaN. The single crystal or polycrystalline GaN for the source material may be grown by any number of methods known in the art. Other forms of source material may also be used, for example, amorphous GaN or a GaN precursor such as Ga metal or a Ga compound. In one embodiment, the source GaN comprise one or more particles that are sufficiently large in size so as not to pass through the openings in a baffle, described below, that separates the source region, where the source material is located, from the crystal growth region, where a nucleation center is located, of a chamber or capsule, as discussed in more detail below.

Nucleation for GaN growth may be induced on the crystal growth portion of the capsule at a nucleation center without a seed crystal; such as a portion of the container wall, or with a non-GaN seed crystal such as sapphire, for example. It is preferred, however, that a GaN seed crystal is provided, because the process is easier to control and the quality of the grown crystal is higher.

In one embodiment, the seed crystal is larger than 1 mm in diameter and of high quality, being substantially free of tilt boundaries and having a dislocation density less than about 10⁸cm⁻². In a second embodiment, the seed crystal has a dislocation density less than about 10⁵cm⁻². A variety of types of GaN seed crystals may be provided, including an epitaxial GaN layer on a non-GaN substrate such as sapphire or SiC, a free-standing GaN film grown by HVPE, sublimation, or metal organic chemical vapor deposition (MOCVD), or a crystal grown in a supercritical fluid in a previous run. In yet another embodiment, the GaN seed crystals have a dislocation density below 10⁴cm⁻² and are substantially free of tilt boundaries, resulting in GaN crystals that similarly have a dislocation density below about 10⁴cm⁻² and are substantially free of tilt boundaries.

It is known that using GaN seed crystals contain one or more tilt boundaries is a convenient way to produce large-area seed crystals with tilt boundaries. For example, GaN crystals grown by HVPE with a dislocation density in the range of 10⁵-10⁸ cm⁻² may be employed as seed crystals. However, heteroepitaxy produces mosaic structures, and as the thickness of the heteroepitaxial film increases, for example, above 1 mm, the presence of tilt boundaries in the thick film becomes increasingly apparent.

In the present invention, we have surprisingly found that GaN crystals with a dislocation density below about 10⁴cm⁻² that are substantially free from tilt boundaries may be grown from seed crystals with a dislocation density of about 10⁵ -10⁸ cm⁻² and tilt boundaries. The present inventors found that by optimizing the solvent fill, mineralizer concentration, temperature, and temperature gradient, growth on the seed will occur in both the c direction (that is, (0001) and (0001̅), along the c-axis) and perpendicular to the c direction (for example, in the (11̅00) and (112̅0) directions), and that the dislocation density in bulk GaN grown in the c-direction is reduced significantly.

The seed may have any crystallographic orientation, as growth occurs on all exposed GaN surfaces. Grown crystals are typically terminated predominantly by (0001), (0001̅), and (11̅00) facets, and all these orientations are suitable for seed surfaces. In one invention, the (112̅0) surfaces are used for favorable seed surface orientations.

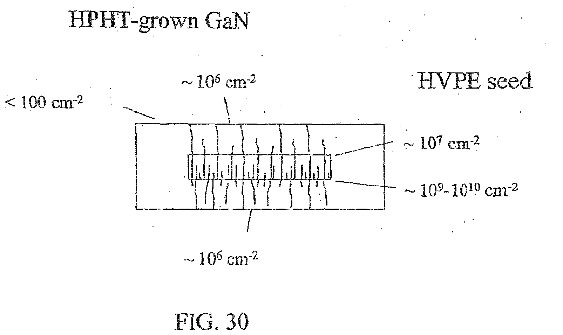

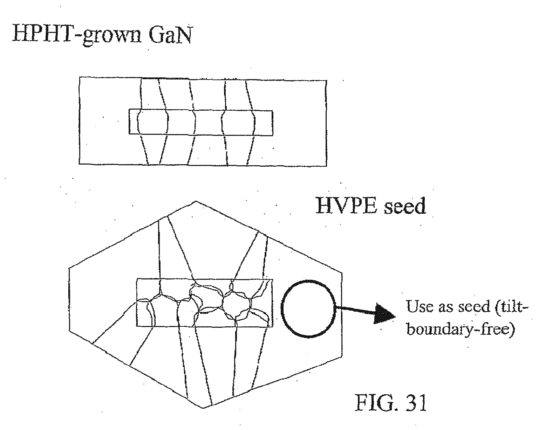

In one embodiment, growth of a 300-800 µm thick layer above a c-oriented seed crystal containing approximately 10⁷ dislocations cm⁻² results in a GaN crystal with approximately 1-3×10⁶ dislocations cm⁻² in the region above the seed, as shown in Fig. 30, which is a schematic illustration of the evolution of threading dislocations in bulk GaN grown on a c-oriented seed crystal containing threading dislocations. However, the bulk GaN grown laterally with respect to a c-oriented seed crystal has fewer than 10⁴ dislocations cm⁻². In one embodiment, the bulk GaN grown has fewer than 10³ dislocations cm⁻², and in yet another embodiment, fewer than 100 dislocations cm⁻², as illustrated in Fig. 30. Tilt boundaries that are present in a c-oriented seed crystal will propagate during growth in the c direction, resulting in a grain structure in bulk GaN grown above the seed that is similar to that in the seed, as illustrated schematically in Fig. 31, which is a schematic illustration of the evolution of tilt boundaries in bulk GaN grown on a c-oriented seed crystal containing tilt boundaries. However, tilt boundaries will radiate outward in bulk GaN that is grown laterally, resulting in progressively larger domains that are free of tilt boundaries as the crystal becomes larger, as illustrated in Fig. 31.

The position of the tilt boundaries may be determined by a method that is well known in the art, such as x-ray diffraction, x-ray topography, or simple optical reflection, and a new seed crystal may be cut from the laterally-grown GaN that is entirely or substantially free of tilt boundaries. Bulk GaN grown from this new seed crystal are surprisingly found to be substantially free of tilt boundaries, with a dislocation density below 10⁴ cm⁻², in one embodiment, less than 10³ cm⁻² and even below 100 dislocations cm⁻² in other embodiments.

Mineralizer. The mineralizer may comprise at least one of (i) alkali and alkaline-earth nitrides, such as Li₃N, Mg₃N₂, and Ca₃N₂; (ii) amides, such as LiNH₂, NaNH₂, and KNH₂; (iii) urea and related compounds; (iv) ammonium salts, such as NH₄F and NH₄Cl; (v) rare earth, halide, sulfide, or nitrate salts, such as CeCl₃, NaCl, Li₂S, or KNO₃; (vi) azide salts, such as NaN₃; (vii) other Li salts; (viii) combinations of the above; and (ix) compounds formed by chemical reaction of at least one of the above with Ga and/or GaN.

The mineralizers may be provided as solids or as additives dissolved in fluids, such as solvents. The use of alkaline-earth or rare-earth mineralizers have the additional advantage of acting as a getter for adventitious oxygen in the growth medium, allowing for the growth of undoped GaN crystals with low n-type carrier density.

Alternatively, the mineralizer can be formed *in situ.* At least one of lithium, sodium, potassium, rubidium, cesium, magnesium, calcium, strontium, barium, or a rare-earth metal may be provided, which then react with the ammonia solvent to form the mineralizer.

Low Oxygen Impurity Level. In one embodiment of the invention, impurities in the grown crystals may be kept limited to appropriately low levels by controlling the impurity level in the raw materials (source gallium nitride, mineralizer, and solvent). In a second embodiment, the oxygen concentration in the grown crystals below 10¹⁹ cm⁻³ is achieved by holding the total oxygen content in the raw materials and capsule below 15 parts per million, expressed with respect to the weight of the final crystal. In another embodiment, an impurity level below 3×10¹⁸ cm⁻³ is obtained by holding the total oxygen content below an appropriate level. In yet another embodiment, a level of 3×10¹⁷ cm⁻³ may be achieved by holding the total oxygen content in the raw materials and capsule below 1.5 parts per million.

Optional Dopant Source. In one embodiment, a dopant source is added to the process, in order to provide n-type, semi-insulating, p-type, magnetic, or luminescent GaN crystals. Adventitious impurities such as oxygen or carbon will otherwise normally render the crystals n-type. Dopants such as O, Si, or Ge (n-type) and Be, Mg or Zn (p-type) may be added as impurities in the source GaN. Alternatively, the dopants may be added as metals, salts, or inorganic compounds, such as Si, Si₃N₄, SiCl₄, BeF₂, Mg₃N₂, MgF₂, Zn, ZnF₂, or Zn₃N₂. GaN crystals with total impurity concentrations below about 10¹⁵-10¹⁶ cm⁻³ are semi-insulating. Typically, however, the concentration of unintentional impurities is higher than 10¹⁶ cm⁻³ and the crystals are n-type.

Semi-insulating GaN crystals may be obtained by doping with at least one of Sc, Ti, V, Cr, Mn, Fe, Co, Ni, Cu, or Zn. Synthesis of semi-insulating GaN (of lower quality than the present invention) by Fe doping is known in the prior art. However, the present inventors have surprisingly found that doping by Co causes the GaN grown by the inventive method to be semi-insulating. Magnetic GaN crystals may be obtained by doping with certain transition metal such as Mn. Luminescent GaN crystals may be obtained by doping with certain transition or rare-earth metals such as Ti, V, Cr, Mn, Fe, Co, Ni, Zr, Hf, Pr, Eu, Er, or Tm. The transition-metal dopants may be added as impurities in the source GaN or as metals, salts, or inorganic compounds, such as Fe, Co, CoF₂, or CrN, or EuF₃, either alone or in combination with one or more additional dopants such as O, Si, Mg, Zn, C, or H. In one embodiment, the dopants are present in concentrations raging from about 10¹⁵ cm⁻³ to about 10²¹ cm⁻³ in the source GaN.

The source gallium nitride, solvent, and mineralizer, whether as a mixture that is compacted or not compacted and, in one embodiment, at least one GaN seed crystal, are then placed inside a capsule. Optionally, additional mineralizer can also be added to the capsule.

The capsule, which will be described hereinafter, can then be filled with a nitrogen-containing solvent, for example at least one of ammonia or hydrazine, or an organic solvent, including but not limited to, methylamine, melamine, or ethylene diamine, and mixtures thereof. The capsule is filled and sealed without admitting air or water, which are undesirable in the gallium nitride formation process.

To fill the capsule without admitting air or water, the capsule is filled and connected to a negative pressure source, such as a vacuum manifold, and evacuated. The capsule is then chilled to a temperature below room temperature (preferably about -72 °C or below) and vapor-phase solvent can be admitted to the manifold. The vapor-phase solvent then condenses in the capsule. For example, if the nitrogen-containing solvent comprises ammonia, the condensation can be performed at dry ice or liquid-nitrogen temperatures. The capsule can then be isolated so as to seal the capsule by closing a valve to the negative pressure source. The capsule can then be separated from at least one of the manifold or the valve by a pinching-off step using a cold welding apparatus, which is well known in the art. The pinching-off step is particularly effective if the capsule is copper. The integrity of the seal may be enhanced by optional arc-welding.

After the capsule is sealed, it is then disposed in a pressure cell, and subjected to high pressure and high temperature conditions in an appropriate high pressure high temperature (HPHT) system. The HPHT conditions are maintained for a length of time sufficient to dissolve a substantial portion of the source gallium nitride and re-precipitate it onto at least one gallium nitride crystal, gallium nitride boule, or gallium nitride crystal seed.

In one embodiment of the invention, the pressure is in a range from greater than about 5 kbar to about 80 kbar. In another embodiment, the temperature for the gallium nitride crystal growth process is in a range between about 550 °C and about 3000 °C. The HPHT system is then allowed to cool and the high pressure is relieved.

Example of a Process for Forming High Quality Single Crystal. In one embodiment of the invention, the source material and one or more seeds, if used, are placed in a pressure vessel or capsule that is divided into at least two regions by means of a porous baffle. An exemplary capsule is described in U.S. Patent Publication No. US2003/0141301A1, entitled "High Temperature High Pressure Capsule for Processing Materials in Supercritical Fluids," hereby incorporated by reference in its entirety.

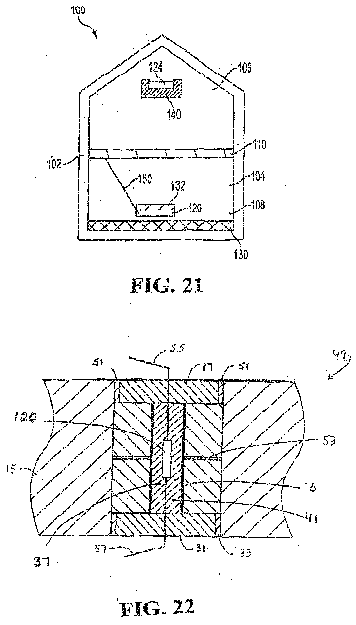

Figure 21 illustrates an exemplary capsule 100 that can be used in the process of the invention. The capsule 100 includes a wall 102, which can be sealed to surround a chamber 104 of the capsule 100. The chamber is divided into a first region 108 and a second region 106 separated by a porous baffle 110. During crystallization growth the capsule 100 contains a seed crystal 120 or other nucleation center and a source material 124 separated from each other by the baffle 110. The source material 124 and the seed crystal 120 may be positioned in the second region 106 and the first region 108, respectively, for example. The capsule 100 also contains a solvent material 130. During the growth process, described below, a grown crystal 132 is grown on the seed crystal 120 and the solvent is in a supercritical state. The baffle 110 may comprise, for example, a plate with a plurality of holes in it, or a woven metal cloth. The fractional open area of the baffle 110 may be between 1 % and 50%, and preferably between about 5% and about 40%. Transport of nutrient from the source material 124 to the seed crystal 120 or grown crystal 132 is optimized in the solvent as a supercritical fluid if the colder portion of the capsule 100 is above the warmer portion, so that self-convection stirs the fluid. In many solvents the solubility of GaN increases with temperature, and in this case the source material 124 should be placed in the bottom warmer portion of the capsule and the seed crystal 120 in the top colder portion of the capsule.

In one embodiment, the seed crystal 120 is hung by a wire (150) through a hole drilled through the seed, so as to allow crystal growth in all directions with a minimum of interference from wall 102 or other materials. The hole may be drilled by a laser, a diamond or abrasive drill, or an ultrasonic drill, for example. The seed crystal 120 may alternatively be hung by tying a wire around one end of the seed.

In the case of some solvents, however, the solubility of GaN decreases with temperature. In this case, the seed crystal 120 may be placed in the lower warmer portion of the capsule and the source material 124 in the upper colder portion of the capsule. In one embodiment, the source material 124 is placed in a porous basket 140 displaced from the baffle 110 rather than immediately contacting the baffle 110, as the latter arrangement may impede transport of fluid and nutrient through the baffle 110.

In one embodiment, a mineralizer may also be added to the capsule 100, in order to increase the solubility of GaN in the solvent, either together with the source material 124 or separately.

The capsule 100 is filled with a solvent 130, i.e., a supercritical fluid under processing conditions. In one embodiment, ammonia is employed as the supercritical fluid solvent 130. Of the free volume in the capsule, i.e., the volume not occupied by the source material, seed(s), and baffle, between 25% and 100% is filled with solvent 130 and the capsule 100 is sealed. In another embodiment, of about between 70% and 95% of the capsule is filled with the supercritical fluid solvent.

In yet another embodiment, ammonia is employed as the supercritical fluid solvent 130 and ammonium fluoride, NH₄F, is employed as the mineralizer. This combination provides the advantage of a relatively high solubility of GaN while not being overly corrosive to the capsule, particularly when the capsule is fabricated from silver. In this case the effective solubility of GaN decreases with temperature. Without wishing to be bound by theory, the inventors believe that GaN undergoes a chemical reaction with the mineralizer and solvent, forming complexes comprising gallium, fluoride, ammonium ion, and ammonia which are soluble in supercritical ammonia. Formation of the complexes is reversible, with an equilibrium constant for formation that decreases with temperature so that formation of free GaN is favored at higher temperature and the effective solubility of GaN decreases with temperature. After ending a crystal growth run with this chemistry, the capsule is typically found to be filled with white needle-shaped crystals. X-ray diffraction analysis indicates that the crystals comprise GaF₃(NH₃)₂ and (NH₄)₃GaF₆, whose structures are known from the literature.

In one embodiment of a method to fill and seal the capsule, the capsule 100 is first cooled to a temperature at which the solvent 130 is either a liquid or solid. Once the capsule 100 is sufficiently cooled, a solvent source is placed in fluid communication with the open chamber of the capsule 100 and solvent is introduced into the chamber, which is open at this point, by either condensation or injection. After a desired amount of solvent 130 is introduced into the open chamber, the chamber is sealed. The chamber may be sealed, for example, by pinching off or collapsing a portion of the wall 102 to form a weld.

The sealed capsule is placed in a vessel capable of generating temperatures between about 550 °C and about 3000 °C, or preferably between about 550 °C and about 1200 °C and a pressure between about 5 kbar and about 80 kbar, or preferably between about 5 kbar and about 20 kbar.

An exemplary pressure vessel is described in U.S. Patent Application No. 09/683,658, to D'Evelyn et al. filed on January 31, 2002, and entitled "Improved Pressure Vessel," hereby incorporated by reference in its entirety. One exemplary pressure vessel of the invention is a zero-stroke type apparatus 49, which allows the operator to independently control both the mean temperature in the cell and the temperature gradient across the cell is shown in Fig. 22, for a zero-stroke-type apparatus, 49.

In this pressure vessel 49, the upper steel endcap 17 is surrounded by an annular pyrophyllite bushing, 51. The lower steel cap 31 is surrounded by an annular pyrophyllite bushing 33. Bushing 51, along with annular pyrophyllite bushing 33, electrically insulates anvils 37 and 41 from die 15. An electrically conductive annulus, 53, is interposed about midway between the top and bottom of heater or heating element 16 in order to divide the reaction cell into an upper section and a lower section. Heating element 16 may be in the form of a heating tube, or a heated foil, ribbon, bar, wire, ring, or combinations thereof. The heating element 16 may comprise at least one of graphite foil, graphite, nichrome, niobium, titanium, tantalum, stainless steel, nickel, chromium, zirconium, molybdenum, tungsten, rhenium, hafnium, platinum, silicon carbide, and combinations thereof. In one embodiment, the heating element 16 may have a non-uniform resistivity along its length to provide a temperature gradient. Non-uniform resistivity may be provided, for example, by providing at the heating element 16 having a non-uniform thickness, by perforating the at least one heating element at selected points, or by providing at least one heating element 16 that comprises a laminate of at least two materials of differing resistivity at selected points along the length of the at least one heating element 16.

Annulus 53 makes contact with heating element 16 along its inner diameter and with die 15 along its outer diameter. Annulus 53 may be formed from, for example, at least one of GRAFOIL^{®} graphite foil, graphite, NICHROME alloy (Ni 60%, Fe 25%, Cr 15)%, niobium, titanium, tantalum, stainless steel, nickel, chromium, zirconium, molybdenum, tungsten, rhenium, hafnium, platinum, silicon carbide, and alloys and combinations thereof.

The main heater power is applied between anvils 37 and 41, and differential heater power is applied between die 15 and either anvil 37 or anvil 41. Alternatively, one heater circuit can be applied between die 15 and anvil 37 and the second circuit between die 15 and anvil 41. To monitor or control the temperature at two positions within the cell, for example, at the top and bottom of the sample, temperature sensors, 55 and 57, are inserted through cell components to the desired position. In one embodiment of the invention, temperature sensors are in the form of thermocouples, thermistor, an optical fiber coupled to an optical pyrometer, or any combination thereof.

The cell or capsule 100 is self-pressurizable up to between 1 atm (∼ 1 bar) and about 80 kbar. In one embodiment, capsule 100 is pressurizable up to between about 5 kbar and about 80 kbar. The capsule 100 is typically formed from a malleable metal such as, but not limited to, copper, silver, gold, platinum, stainless steel or the like. In another embodiment, the capsule 100 has a low hydrogen permeability and is chemically inert with respect to the supercritical fluid and the material to be processed within the capsule 100. With minor adaptations, the above embodiment of the zero-stroke apparatus of the invention can be applied to a belt apparatus, a piston-cylinder apparatus, a multi-anvil press apparatus, or a split-sphere apparatus for growing the GaN crystals of the invention.

The capsule 100 is heated to the growth temperature between about 550 °C and 1200 °C, at an average rate between about 1 °C/hr and 1000 °C/hr. A temperature gradient may be present in the capsule, due to asymmetric placement of the capsule in the cell, non-symmetric heating, or the like, as described above with respect to the pressure vessel 48. This temperature gradient has the effect of creating a supersaturation throughout the heating sequence, which the inventors have found promotes spontaneous nucleation.

In one embodiment of the present invention, the temperature gradient at the growth temperature is initially held small, less than about 25 °C. In another embodiment, less than about 10 °C, for a period between about 1 minute and 2 hours, in order to allow the system to equilibrate in an equilibrium stage. The temperature gradient as used in this application is the difference in the temperature at the ends of the capsule 100, for example, where the control thermocouples are located. The temperature gradient at the position of the seed crystal or nucleation center with respect to the temperature at the position of the source material is likely to be somewhat smaller.

Optionally, the temperature gradient is set in the equilibrium stage to be opposite in sign to that where crystal growth occurs on the nucleation center (i.e., so that etching occurs at the nucleation center and growth occurs on the source material) so as to etch away any spontaneously-nucleated crystals in the region of the capsule where the nucleation center is provided that may have formed during heating. In other words, if the crystal growth occurs for a positive temperature gradient, then the temperature gradient is set to be negative, and vice versa.

After this equilibration period, a growth period may be provided where the temperature gradient is increased in magnitude and has a sign such that growth occurs at the seed crystal at a greater rate. For example the temperature gradient may be increased at a rate between about 0.01 °C/hr and 25 °C/hr, to a larger value where growth is faster. In the crystal growth stage, the temperature gradient may be held at a magnitude of between 5 °C and 300 °C and may be adjusted upward or downward during growth. Optionally, the temperature gradient may be changed to have a sign opposite to the sign where growth occurs at the seed crystal. The sign of the gradient may be reversed one or more additional times in order to alternately etch away any spontaneously-formed nuclei and promote growth on one or more nucleation centers or seed crystals. The HPHT conditions are maintained for a length of time sufficient to dissolve a substantial portion of the source gallium nitride and precipitate it onto at least one gallium nitride crystal, gallium nitride boule, or gallium nitride crystal seed.

At the conclusion of the growth period, the temperature of the capsule 100 may be ramped down at a rate between about 1 °C/hr and 1000 °C/hr, and preferably between about 1 °C/hr and 300 °C/hr so as to minimize thermal shock to the grown crystal. The cell, including the capsule and pressure medium, is removed from the pressure vessel 48 and the capsule 100 is removed from the cell.

The solvent in the capsule 100 may be conveniently removed by chilling the capsule to reduce the vapor pressure of the solvent below 1 bar, puncturing the capsule 100, then allowing it to warm so that the solvent evaporates. The capsule is cut open and the grown crystal(s) removed. The crystal(s) may be washed by an appropriate wash, such as, for example, at least one of water, alcohol or other organic solvent, and mineral acids to remove mineralizer. The mineral acids for washing the gallium nitride crystals include, but are not limited to, hydrochloric acid (HCl) and nitric acid (HNO₃).

The inventors have surprisingly found that, with the choice of at least one of HF, NH₄F, GaF₃, or their reaction products with Ga, GaN, NH₃ or with each other at fluoride concentrations of 0.5 to 90 atomic % in NH₃, growth temperatures between 600 and 1000 °C, and temperature gradients between 10 and 75 °C, GaN growth rates of at least 5 µm/hr may be achieved. In one embodiment of the invention, the growth rate is at least 10 µm/hr. In another embodiment, the growth rate is at least 20 µm/hr. In yet a fourth embodiment, growth rates are in excess of 50 µm/hr.

The foregoing description of the process for forming the GaN single crystal substrate is intended to be illustrative only, and should not be construed in any limiting sense. Other methods for forming the single crystal will be obvious to those skilled in the art, but are intended to fall within the scope of the present disclosure.

Crystal Characterizing Methods: The crystal may be characterized by standard methods that are known in the art. The quality of the single crystal may be indicated by characterization techniques, such as photoluminescence, which occurs at the band edge at room temperature for GaN.

For determining the dislocation density, cathodoluminescence (CL) and etch pit density may be conveniently utilized. CL imaging provides a non-destructive measure of dislocation density, and requires no sample preparation. Dislocations are non-radiative recombination centers in GaN, and therefore appear in CL as dark spots. One can simply measure the concentration of dark spots in CL images to determine the dislocation density.

A second convenient method, which may be more definitive in some cases, is etch pit density. One such etch method, for example, is a vapor-phase HCl etch, as described by T. Hino et al., Appl. Phys. Lett. 76, 3421 (2000) incorporated by reference.

The present inventors have tested both of these methods with a commercial GaN sample grown by HVPE. Dislocation densities (dark-spot densities or etch pit densities) of 1-2 ×10⁷ cm⁻² were obtained, in excellent agreement with the values reported by the supplier and other researchers on similar material.

In another embodiment, the dislocation density is determined transmission electron microscopy (TEM) on a thin section, as is well known in the art.

The optical absorption and emission properties of the grown GaN can be determined by optical absorption, scattering and photoluminescence spectroscopies, as are well known in the art. The electrical properties can be determined by Van der Pauw Hall effect measurements, by mercury-probe CV, and by hot-probe techniques.

Processing of the Formed Crystal. The crystal may be further processed and sliced into one or more wafers, lapped, polished, and chemically polished. The wafer or substrate preferably has a thickness between about 0.01 and 10 mm, most preferably between about 0.05 and 5 mm. This single crystal gallium nitride crystal, and wafers formed therefrom, are useful as substrates for electronic and optoelectronic devices.

After cutting, the substrate is then polished to a mirror finish using mechanical-polishing techniques known in the art. In the event that subsurface damage may remain after the polishing process, the damage may be removed by several methods that are known in the art, including chemically assisted ion beam etching, reactive ion etching, or chemo-mechanical polishing. The residual damage may also be removed by heating the wafer to a temperature between about 700 and 1500 °C in a nitrogen-containing atmosphere, for example, N₂ or ammonia at a partial pressure between about 10⁻⁸ mbar and 20,000 bar.

The crystal may be sliced into one or more wafers by methods that are well known in the art. The GaN crystal or wafer is useful as a substrate for epitaxial AlₓIn_{y}Ga_{1-x-y}N films where 0≤x≤1, 0≤y≤1 and 0≤x+y≤1, light emitting diodes, laser diodes, photodetectors, avalanche photodiodes, transistors, diodes, and other optoelectronic and electronic devices.

Characteristics of Crystals Formed by Process of Invention. The above described embodiments provide improved nucleation control by including an equilibration period in the temperature program, in which the temperature gradient is substantially reduced, or even set to be zero or negative, with respect to the gradient during crystal growth, and by hanging the seed crystal within the growth chamber. The improved crystal growth method provides high quality, large area GaN crystals, with the crystals being true single crystals, originating from a single seed rather than being formed by coalescence of multiple growth centers, being substantially free of grain boundaries, tilt boundaries, and the like, and having an oxygen impurity level of a level below 10¹⁹ cm⁻³.

In one embodiment of the process of the invention, large single gallium nitride crystals are yielded, for example single GaN crystals having a diameter and thickness ranging from about 0.02 inch (about 0.05 cm) to about 12 inches (about 30 cm). In another embodiment, a size in a range from about 2 inches to about 6 inches.

In yet another embodiment, the GaN single crystals formed are substantially transparent, with an absorption coefficient below 100 cm⁻¹. In another embodiment, the substrates have carrier mobilities above about 100 cm²/V-s and strain, with respect to undoped GaN homoepitaxial layers, below about 0.005%.

A GaN single crystal formed by the above method may be characterized using etch pit density measurements, photoluminescence, and optical absorption techniques. In one embodiment, the GaN crystal formed contains less than 10⁴ threading dislocations per cm². In one embodiment, the GaN crystal formed contains less than 10³ dislocations per cm². In another embodiment, the single crystal formed is characterized by a dislocation density below 100 cm⁻², a photoluminescence spectrum which peaks at a photon energy of between about 3.38 and about 3.41 eV at a crystal temperature of 300°K, and has an optical absorption coefficient below 5 cm⁻¹ for wavelengths between 700 nm (red) and 465 nm (blue).

A GaN single crystal formed by the above method may also be characterized by infrared transmission spectroscopy and by Raman spectroscopy. In contrast to GaN grown by other methods, the GaN grown in one embodiment has several sharp absorption peaks in the range of 3050 to 3300 cm⁻¹, with a maximum absorption near 3175 cm⁻¹. The crystal is annealed to 750 °C in high purity nitrogen for 30 min and the infrared spectrum is re-measured. The absorption peaks in the range of 3050 to 3300 cm⁻¹ are found essentially unchanged, indicating a high stability of the species responsible for the absorption peaks. Based on predictions of vibrational frequencies of 3100 - 3470 cm⁻¹ for V_{Ga}H₁ - V_{Ga}H₄ (which may overestimate the actual frequencies by about 200 cm⁻¹) and the observation of infrared absorption features at 3020-3050 cm⁻¹ and at 3140 cm⁻¹ in hydrogen-implanted GaN [M. G. Weinstein et al., Appl. Phys. Lett. 72, 1703 (1998)], it is believed that the absorption peaks between 3150 and 3200 cm⁻¹ in the samples of the embodiment correspond to V_{Ga}H₃ and V_{Ga}H₄, that the absorption peaks observed between 3000 and 3150 cm⁻¹ in both our crystal and hydrogen-implanted GaN correspond to V_{Ga}H₁ and V_{Ga}H₂, and that other minor peaks may be associated with the presence of other impurities or defects. Thus, the presence of an infrared absorption feature near 3175 cm⁻¹ in GaN crystals grown herein indicates passivation of gallium vacancies, and the persistence of the infrared feature upon high temperature annealing indicates that this passivation is quite stable. Depending on the concentration of hydrogenated gallium vacancies in the GaN crystal, the absorbance per unit thickness of the 3175 cm⁻¹ peak may lie in the range between about 0.01 and 200 cm⁻¹.

In another embodiment of a GaN crystal grown by the inventive method, additional evidence for the passivation of point defects in can be obtained by Raman spectroscopy. In one example, a total of five peaks are observed in two configurations between 400 and 800 cm⁻¹. The peaks, with the assignments in brackets, are observed at 530 cm⁻¹ [A₁(TO)], 558 cm⁻¹ [E₁ (TO)], 569 cm⁻¹ [E₂ (high)], 734 cm⁻¹ [A₁(LO)], and 742 cm⁻¹ [E₁(LO)]. These values are all within a few cm⁻¹ of accepted values for pure GaN reported in the literature. Additionally, a broad peak associated with phonon-plasmon coupling is not observed. The observation of unshifted LO modes and the absence of a phonon-plasmon mode indicates a carrier concentration below 10¹⁷ cm⁻³, based on Raman measurements reported in the literature on GaN with carrier concentrations between 10¹⁶ cm⁻³ and 10²⁰ cm⁻³. The total impurity concentration in this crystal is above 10¹⁹ cm⁻³. The drastic reduction in carrier concentration relative to the impurity concentration indicates a high degree of compensation, most likely due to hydrogen.

The incorporated hydrogen is believed to be benign or possibly even beneficial. Typical gallium nitride crystal growth methods do not provide passivation of gallium vacancies by hydrogenation, even if hydrogen is in the growth system. For example, infrared transmission spectroscopy on 300-400 mm thick GaN samples grown by hydride vapor phase epitaxy (HVPE) revealed weak absorption features near 2850 and 2915 cm⁻¹ associated with another defect, but no absorption features between 3100 and 3500 cm⁻¹ that could be assigned to hydrogenated Ga vacancies were observed in the HVPE gallium nitride material.

Within the visible spectrum, the gallium nitride boule typically exhibits substantial transparency. The optical absorption coefficient for nominally undoped crystals is generally less than 5 cm⁻¹ between 465 nm and 700 nm. Doped crystals exhibit similarly low absorption, although some free carrier absorption may be introduced at high carrier concentrations. Moreover, dopants, substitutional or interstitial impurities, vacancy complexes, or other point defects may introduce narrow peaks of higher absorption within the visible range. Such point defect-related narrow absorption peaks typically do not, however, significantly reduce the substantial transparency of the crystal in the visible for purposes such as backside extraction of emitted light.

In one embodiment of the invention, wherein a gallium nitride boule is grown using at least one of NH₄F, GaF₃, or other compounds obtainable by reaction of Ga, GaN, NH₃, and HF, as mineralizer, the gallium nitride typically contains greater than about 0.04 ppm fluorine. In yet another embodiment, between about 0.04 and 1 ppm fluorine. By contrast, GaN crystals grown with fluorine-free mineralizers typically contain less than 0.02 ppm fluorine. The incorporated fluorine is suitably quantified by glow discharge mass spectrometry, secondary ion mass spectrometry, fusion-dissolution followed by inductively-coupled plasma or fluorine-selective-electrode analysis, or the like. As with the case of incorporated hydrogen, the incorporated fluorine is believed to be benign or possibly even beneficial. Bond lengths to fluorine in molecules or solids are typically only slightly larger than the corresponding bonds to hydrogen, so that fluorine may play a similar role passivating defects.

In one embodiment, after the crystal has been formed, the substrate for the device fabrication is cut from a boule formed by the method described above. In another embodiment of the invention, the resulting substrate has a thickness between about 0.01 and 10 mm, most preferably between about 0.05 and 5 mm.

In one embodiment of the invention, a GaN substrate for device fabrication consists of an (0001)-oriented GaN wafer is cut from a boule that grown using a supercritical solvent at a temperature greater than about 550 °C and a pressure greater than about 5 kbar. The substrate is found to be substantially free of tilt boundaries, has a dislocation density less than about 10⁴ cm⁻². In another embodiment, the substrate is of n-type and substantially transparent, with an optical absorption coefficient less than 5 cm⁻¹ for wavelengths between 700 nm (red) and 465 nm (blue). In still another embodiment, the substrate is magnetic, and in another, is luminescent. In another embodiment, the substrate has an infrared absorption peak near 3175 cm⁻¹ with an absorbance per unit thickness between about 0.01 and 200 cm⁻¹. In one embodiment, the crystal is doped with at least one of H, Be, C, O, Mg, Si, Ca, Sc, Ti, V, Cr, Mn, Fe, Co, Ni, Cu, Zn, Ge, Zr, Hf, or a rare earth metal at a concentration between about 10¹⁶ cm⁻³ and about 10²¹ cm⁻³.

In another embodiment of the invention, the wafer is a wurtzite-structure material. In one embodiment, the (0001)-oriented GaN wafers has a Ga-terminated (0001) face and an N-terminated (0001̅) face. The wafer may also be prepared in other orientations, such as, but not limited to, the non-polar (101̅0) and (112̅0) orientations and surfaces vicinal (off-axis) with respect to the (0001) or (0001̅) faces. The (0001) Ga face is useful for deposition of LED and LD device structures, but other orientations are also advantageous. For example, the use of a nonpolar (101̅0) or (112̅0) orientation avoids the presence of piezoelectric fields within the device structure.

In yet another embodiment, the wafer comprises n-type GaN, with an electrical resistivity less than about 100 Ω-cm. In another embodiment, the wafer comprising n-type GaN has an electrical resistivity less than about 100 Ω-cm. In a third embodiment, the electrical resistivity is less than about 10 Ω-cm. In a fourth embodiment, of less than about 1 Ω-cm. In yet another embodiment the wafer comprises p-type GaN with an electrical resistivity below about 100 Ω-cm, and in still another embodiment the wafer comprises semi-insulating GaN with an electrical resistivity above about 10⁵ Ω-cm.

In one embodiment, the orientation used for growth is (0001) Ga. In another embodiment, the wafer has a dislocation density less than about 10⁴ cm⁻². In yet another embodiment, below about 10³ cm⁻², and in yet another, below about 100 cm⁻². In yet a fifth embodiment, the substrates formed may have carrier mobilities above about 100 cm²/V-s and strain, with respect to undoped GaN homoepitaxial layers, below about 0.005%.

Electronic Device Fabrication. As used herein, an electronic device refers to any device which includes a stack of layers which has the characteristics of the GaN crystal of the invention, namely, a maximum dimension of at least 2 millimeters, a dislocation density of less than 10⁴ cm⁻², substantially no tilt boundaries, and an oxygen impurity level of less than 10¹⁹ cm⁻³, electrical contacts for being connected to an electrical energy source for operating the device. In one embodiment of the invention, the electronic device has a lateral dimension of at least about 100 µm. In another embodiment, the electronic device has a lateral dimension of at least about 1 mm. In another, at least about 2 mm. In still another, at least about 5 mm.

Examples of electronic devices include optoelectronic devices such as light emitting diodes (LED), laser diodes (LD), resonant cavity light emitting diodes (RCLED's), vertical cavity surface emitting lasers (VCSEL's), and photodetectors; various types of transistors, such as MESFETs, MOSFETs, MISFETs, BJTs, HBTs, HEMTs, power vertical MOSFETs, power vertical JFETs, and cascode switches; and thyristors, Schottky rectifiers, and p-i-n diodes.

In one embodiment of an active device structure, the device may be fabricated by molecular beam epitaxy (MBE) or metalorganic vapor-phase epitaxy (MOVPE), also known as OMVPE or MOCVD, in which a semiconducting nitride film of one or more elements of Group III and/or Group V of the Periodic Table is disposed on the GaN crystal of the present invention. These deposition procedures are known in the art. In one embodiment, the wafer or substrate is placed in a growth reactor, which is then evacuated. Residual surface defects are annealed, or adventitious contaminants removed, by heating the wafer to a temperature between about 900 and 1200 °C in an atmosphere containing ammonia at a partial pressure between 10⁻⁶ mbar and 1 bar.

In one embodiment, the device structure is formed by homoepitaxial deposition of a number of GaN based semiconductor layers. Thus, at least one GaN based semiconductor layer is formed on the substrate. Each layer in the structure is formed by condensation of atomic species such as Ga, Al, In, and Si, or decomposition of organometallic precursors in a nitrogen-containing atmosphere on the substrate surface. In one example, the nitrogen-containing atmosphere includes nitrogen, ammonia or hydrazine and may be partially or completely decomposed before contact with the substrate surface. A carrier gas such as H₂ or He may be used. In another example, organometallic precursors may be used. Precursors for MOVPE include, but are not limited to, trimethylgallium, Ga(CH₃)₃, trimethylaluminum, Al(CH₃)₃, and trimethylindum, In(CH₃)₃. Suitable dopant precursors (if the layer is to be doped) include but are not limited to silane, SiH₄, for n-type material, and bis-(cyclopentadienyl)magnesium (Mg(c-C₅H₅)₂) or dimethyl zinc, Zn(CH₃)₂, for p-type material. After the annealing step to reduce residual surface damage, further layers of the electronic device structure are formed.

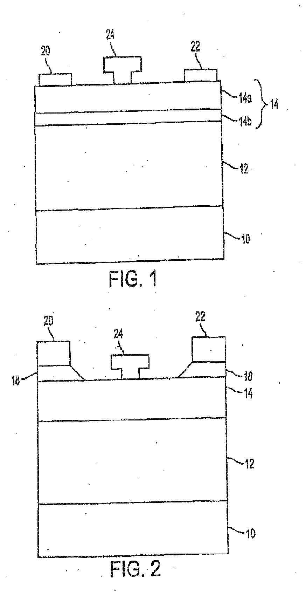

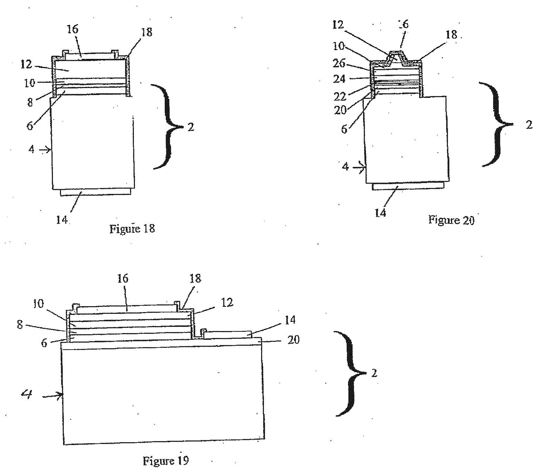

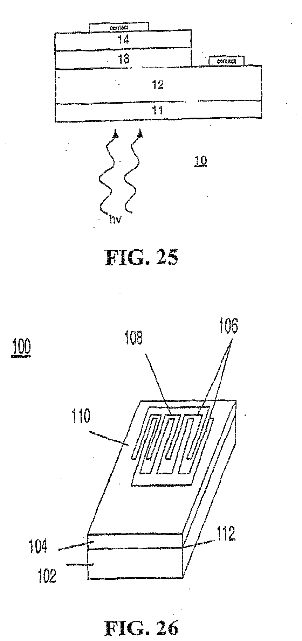

Examples of Device Embodiments of Invention. Examples of some of the device embodiments of the invention are illustrated in Figures 1-17, which comprise (i) a single-crystal GaN substrate; (ii) at least one epitaxial GaN based layer; and (iii) at least two electrical contacts. Figures 18 and 19 illustrate a homoepitaxial LED. Figure 20 illustrates a homoepitaxial LD. Figures 26-28 illustrate homoepitaxial photodiodes.

With respect to Figures 1-3, they illustrate HEMT devices according to one embodiment of the invention. Figure 1 illustrates a first embodiment of a HEMT. After the annealing step described above, a buffer layer 12 is formed on the substrate 10. In this application, buffer layer has a different meaning than the "buffer layer" often described in the GaN device art, which is a poorly-crystallized layer that acts as a transition layer or nucleation layer between a non-GaN substrate such as sapphire or SiC and an epitaxial GaN layer. The buffer layer 12 may be, for example, Al*ₓ*In*_{y}*Ga_{1-*x-y*}N, wherein 0 ≤ *x, y* ≤ 1, 0 ≤ *x* + *y* ≤ 1. In one embodiment, the buffer layer 12 comprises undoped GaN. The buffer layer 12 may have a thickness between about 300 nm and 20 µm. In another embodiment, between 1 and 3 µm.

In the embodiment of Fig. 1 (and of Figure 2 described below) the buffer layer 12 will contain a two-dimensional electron gas (2DEG) and act as a channel layer. The carrier concentration in the buffer layer 12 is below 5×10¹⁶ cm⁻³ in one embodiment, and below 10¹⁵ cm⁻³ in another embodiment. Optionally, the outermost portion of the substrate 10 itself can be utilized as the 2DEG region. After the buffer layer 12 is formed, a barrier layer 14 is formed on the buffer layer 12. The barrier layer 14 has a wider bandgap than the buffer layer 12. The barrier layer 14 may comprise Al*ₓ*In*_{y}*Ga_{1-*x*-*y*}N, wherein 0 ≤ *x*, *y* ≤ 1, 0 ≤ *x* + *y* ≤ 1, and may comprise for example, Al*ₓ*Ga_{1-*x*}-N, where *x* ≈ 0.2-0.3. The incorporation of In into the Al*ₓ*In*_{y}*Ga_{1-*x*-*y*}N barrier layer, with *y* ≈ 0.22 *x,* enables the barrier layer 14 to be approximately lattice matched to the GaN buffer layer 12 despite having a larger bandgap. The barrier layer may also comprise two sub barrier layers 14a and 14b. For example, the sub barrier layer 14b may be formed on the buffer layer 12 and may be AlN and the sub barrier layer 14a may be formed on the sub barrier layer 14b and may be AlGaN. The sub barrier layer 14b is a higher-bandgap layer than the sub barrier layer 14a, and may have, for example, a thickness between about 0.6 and 1.5 nm.

The barrier layer 14 may have a thickness between 5 nm and 50 nm in one embodiment, and between 15 and 25 nm in yet another embodiment. A source contact 20, drain contact 22 and gate contact 24 are formed on the top surface of the device. The source contact 20 and the drain contact 22 are deposited on either side of the device as ohmic contacts to form the source and the drain regions. Suitable compositions for the source and drain contacts 20 and 22 include Ti/Al/Ti/Au, Ti/Al/Ni/Au, and Ti/Al/Pt/Au stacks, wherein each layer of the stack is between about 10 and about 500 nm thick. In one embodiment, the first Ti layer is between 10 and 30 nm thick, the Al layer between 50 and 300 nm thick, and the outermost layers between 30 and 70 nm thick. Deposition may be achieved, for example, by electron beam evaporation, thermal evaporation, or other techniques.

The source and drain contacts 20 and 22 may have, for example, a length between about 50 and 1000 µm. The width of the source and drain contacts 20 and 22 may be between about 20 and 200 µm. In one embodiment, the width is between about 40 and 100 µm. The separation between the source and drain contacts 20 and 22 may be between about 0.2 µm and about 10 µm. In one embodiment, the separation is between 0.5 and 2 µm.

Following the deposition of the source and drain contacts 20 and 22, the structure is annealed, at a temperature between about 500 °C and 950 °C. In one embodiment, the annealing temperature is between about 750 and 870° C, in order to achieve an ohmic contact.

The gate contact 24 is deposited between the source and the drain contacts on top of the barrier layer 14 as a Schottky gate. The length of the gate contact 24 may be between about 20 and 1000 µm in one embodiment, and between about 50 and 500 µm in a second embodiment, and with the width being between about 50 nm and 1 µm in a third embodiment. Suitable compositions for the gate contact 24 include Ni/Au and Pt/Au stacks, wherein the first layer of the stack is between about 20 and 200 nm and the Au layer is between about 100 and 1000 nm thick. Deposition may again be achieved by electron beam evaporation, thermal evaporation, or other techniques. The structure is not annealed, so as to retain Schottky rectification behavior.

The HEMT of Figure 2 is similar to that of Figure 1. The HEMT of Figure 2, however, includes a contact layer 18 formed between the source and drain contacts 20 and 22 and the barrier layer 14, and a trench formed in the contact layer 18 to expose the barrier layer 14, with the gate contact 24 formed on the barrier layer 14. The contact layer 18 may comprise n-doped Al*ₓ*In*_{y}*Ga_{1-*x*-*y*}N, wherein 0 ≤ *x, y* ≤ 1, 0 ≤ *x* + *y* ≤ 1, and may comprise for example n-type GaN with a carrier concentration greater than about 2×10¹⁸ cm⁻³. The contact layer 18 may have a thickness, for example, of between 10 and 200 nm. The contact layer 18 is less oxidation prone than the barrier layer 14, due to a reduced Al concentration, and also forms more reliable ohmic contacts.

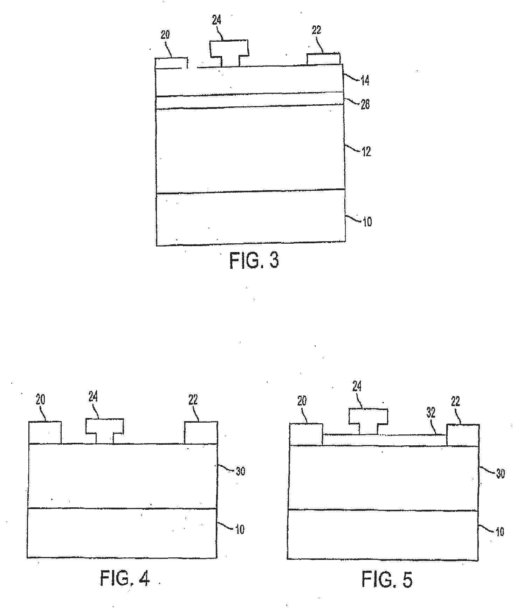

The HEMT of Figure 3 is similar to that of Figure 1. The HEMT of Figure 3, however, includes a channel layer 28 formed between the buffer layer 12 and the barrier layer 14. The channel layer 28 has a narrower bandgap than the buffer layer 12 and will contain the 2DEG. The channel layer 28 may comprise Al*ₓ*In*_{y}*Ga_{1-*x-y*}N, wherein 0 ≤ *x*, y ≤ 1, 0 ≤ *x* + *y* ≤ 1, and may be In*ₓ*Ga_{1-*x*}N, where *x* ≈ 0.05-0.15. The channel layer 28 may have a thickness between 3 nm and 20 nm, or more preferably between 5 and 10 nm.

Figure 4 illustrates an embodiment where the device is a MESFET. The MESFET device is essentially a simplified version of the HEMT, wherein GaN is used throughout the semiconductor structure and there is no barrier layer. A GaN channel layer 30 is formed on the GaN substrate 10. The source, drain and gate contacts 20, 22 and 24 may be formed in a similar fashion to that described with respect to Figure 1. Optionally, the ohmic contacts are improved by means of a contact layer (not shown) analogous to that shown in Figure 2 or, more simply, by ion implantation of an n-type dopant such as Si into the region directly below the source and drain contacts 20 and 22. The MESFET may have somewhat inferior performance characteristics as compared to the HEMT but is simpler and cheaper to fabricate.

In another embodiment, shown in Fig. 5, the device is a MOSFET or MISFET. The MOSFET/MISFET is similar in structure to the MESFET of the embodiment of Figure 4, except that the gate contact 24 is separated from the channel layer 30 by an insulating layer 32, an oxide for a MOSFET or an insulating dielectric for a MISFET. The MOSFET/MISFET is particularly suitable for power electronic applications, as the presence of the oxide or insulator layer protects the GaN layer from oxidation during operation at high currents and/or elevated temperatures. Suitable compositions for the oxide of the insulating layer 32 for a MOSFET include at least one of SiO₂, Sc₂O₃, MgO, Ga₂O₃, and R₂O₃, where R is a rare-earth element such as Gd.

Suitable compositions for an insulating dielectric insulating layer 32 for the MISFET include AlN, SiNₓ, and Si₃N₄, where *x* is between 0 and 1.4. An oxide or insulating layer may also be used to separate the gate from the barrier layer in the HEMT structure of Figure 1.

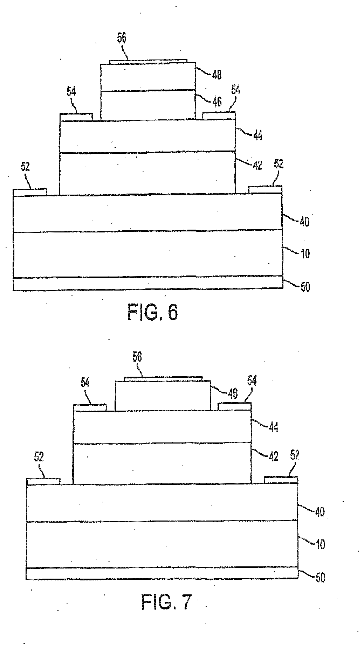

In another embodiment, shown in Fig. 6, the device is an HBT. HBTs are particularly useful for the highest-frequency applications of GaN devices. The HBT can be fabricated in either a npn configuration or a pnp configuration. For simplicity, fabrication of only the npn configuration will be described in detail but fabrication of the pnp configuration is directly analogous with p-type layers of the npn substituted with n-type layers of the pnp configuration and vice versa. The substrate 10 may be a bulk GaN substrate which is semi-insulating, and may have a resistivity greater than 10⁵ Ω-cm. The substrate 10 may also be n-type, preferably with a carrier concentration greater than about 2×10¹⁸ cm⁻³.

A collector layer 42 is formed over the substrate 10. The collector layer 42 may be an n-type layer of Al*ₓ*In*_{y}*Ga_{1-*x-y*}N, wherein 0 ≤ *x, y* ≤ 1, 0 ≤ *x* + *y* ≤ 1, with a thickness between 200 nm and 5000 nm, or more preferably between 400 and 800 nm. The collector layer 42 may comprise n-GaN or n-Al*ₓ*Ga_{1-*x*}N, wherein 0 ≤ *x* ≤ 1 and is doped with a carrier concentration between about 1×10¹⁶ and about 5×10¹⁶ cm⁻³.

In one embodiment, a subcollector layer 40 may optionally be formed between the collector layer 42 and the substrate 10, particularly when substrate 10 is semi-+ insulating. The subcollector layer 40 may comprise, for example, n doped GaN. The thickness of the subcollector layer 40 may be between about 0.2 and 5 µm, or preferably between about 1 and 2 µm, and may have a carrier concentration greater than about 2×10¹⁸ cm⁻³. Subcollector contacts 52, which may be ohmic, are formed on the top surface of the subcollector layer 40. The purpose of the subcollector layer 40 is to improve the performance of the ohmic subcollector contact 52 and, in the case of a semi-insulating substrate, to provide an ohmic contact to the collector layer.

A base layer 44 is formed on the collector layer 42. The base layer 44 may comprise p-type Al*ₓ*In*_{y}*Ga_{1-*x-y*}N, wherein 0 ≤ *x*, *y* ≤ 1, 0 ≤ *x* + *y* ≤ 1, with a thickness between 10 nm and 1000 rim, or more preferably between 50 and 200 nm. The base layer 44 may comprise p⁺-GaN doped with a carrier concentration above about 2×10¹⁸ cm⁻³. The base layer 44 may also be graded from GaN, at the contact with the collector layer, to Al*ₓ*Ga_{1-*x*}N with *x* ≈ 0.05 near the top surface of the base layer 44. Alternatively, a p-Al*ₓ*Ga_{1-*x*}N/GaN superlattice may be deposited on the top surface of the base layer 44.

An emitter layer 46 is formed on the base layer 44. The emitter layer 46 may comprise n-type Al*ₓ*In*_{y}*Ga_{1-*x-y*}N, wherein 0 ≤ *x, y* ≤ 1, 0 ≤ *x* + *y* ≤ 1, with a thickness between 0.5 nm and 1000 nm in one embodiment, and in another embodiment between 50 and 300 nm. The emitter layer 46 has a wider bandgap than the base layer 44. Typically, the emitter layer 46 comprises n-Al*ₓ*Ga_{1-*x*}N, wherein 0.15 ≤ *x* ≤ 0.25 and may be doped with a carrier concentration > 2×10¹⁸ cm⁻³. In one embodiment, the composition of the emitter layer 46 is optionally graded from n-Al*ₓ*Ga_{1-*x*}N with x ≈ 0.05, at the contact to the base layer 44 to n-GaN near the top surface of the emitter layer 46.

+ A cap layer 48 is formed on the emitter layer 46. The cap layer 48 may comprise n - GaN, with a thickness of about 100 nm and a carrier concentration greater than about 2×10¹⁸ cm⁻³. The layers are etched to expose the base layer 44 and, if a top-facing collector contact is desired, a deeper via is etched to expose the subcollector layer 40.

Collector, base, and emitter contacts 52, 54 and 56 are formed. The contacts are preferably ohmic metallic contacts. The emitter contact 56 is deposited on top of the cap layer 48, and the base contact 54 is deposited on the base layer 44 after etching to expose the latter. In one embodiment a collector contact 52 is deposited on the subcollector layer 40, as described above. In another embodiment, the bulk GaN substrate is n-type, with a carrier concentration greater than about 2×10¹⁸ cm⁻³, and a collector contact 50 is deposited on the back surface of the substrate 10, opposite the device structure.

Suitable compositions for the n-type collector and emitter contacts include Ti/Al/Ti/Au, Ti/Al/Ni/Au, and Ti/Al/Pt/Au stacks, wherein each layer of the stack is between about 10 and about 500 nm thick, and deposition is achieved by electron beam evaporation, thermal evaporation, or other techniques. In one embodiment, the first Ti layer is between 10 and 30 nm thick, the Al layer between 50 and 300 nm thick, and the outermost layers between 30 and 70 nm thick. Examplary compositions for the p-type contacts (contacts to the p-type layers) include Ni/Au and Pt/Au stacks, wherein the first layer is between about 20 and 200 nm and the Au layer is between about 100 and 1000 nm thick. Following the depositions the structure is annealed, at a temperature between about 500 °C and 950 °C in one embodiment, and between about 750 and 870° C in a second embodiment, in order to achieve an ohmic contact. As mentioned above, a pnp HBT may be formed by substituting the p-type layers of the pnp HBT with the n-type layers of the npn HBT and vice versa.

Figure 7 illustrates another embodiment, where the device is a BJT. The BJT device of Figure 7 is similar to the HBT of Figure 6. The BJT structure is a simplified version of the HBT, in which unalloyed GaN comprises all the semiconductor layers. Thus, the BJT device of Figure 7 is the same as the device of Figure 6, except that unalloyed GaN is substituted for alloyed GaN layers.

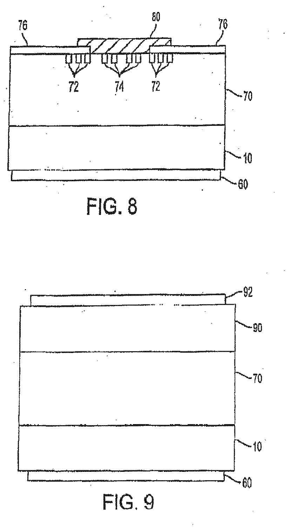

Figure 8 illustrates another embodiment, where the device is a Schottky rectifier. The Schottky rectifier includes a GaN substrate 10. The GaN substrate 10 may be n-type, in one embodiment with a carrier level greater than about 2×10¹⁸ cm⁻³. A voltage blocking layer 70 is formed on the substrate 10. The voltage blocking layer 70 may comprise undoped Al*ₓ*In*_{y}*Ga_{1-*x*-*y*}N, wherein 0 ≤ x, *y* ≤ 1, 0 ≤ *x* + *y* ≤ 1, with a thickness between 1 and 500 µm in one embodiment, and between 50 and 200 µm in another embodiment. The voltage blocking layer 70 has greater thickness for higher blocking voltage requirements. The carrier concentration in the voltage blocking layer 70 may be kept at a low level, for example below 5×10¹⁶ cm⁻³ and in another embodiment below 10¹⁵ cm⁻³. Alternatively, the Schottky rectifier employs a p-type GaN substrate and p-type epilayer.

Optionally, a series of guard rings 72 and junction barrier control rings 74 are formed on the voltage blocking layer 70. The guard rings 72 may be used to reduce electric field crowding at the boundary of the subsequently formed oxide and contact and to increase the blocking voltage. The guard rings 72 and junction barrier control rings 74 may be formed on the voltage blocking layer 70 by ion implantation, for example. The ions for implanting may be Mg or Zn, for example. The carrier level in the region of the rings in one embodiment is greater than about 2×10¹⁷ cm⁻³. An insulator layer 76 is formed on the voltage blocking layer 70. The insulator layer 76 may comprise, for example, at least one of SiO₂, SiNₓ, Sc₂O₃, MgO, Ga₂O₃, and R₂O₃, where *x* is between 0 and 1.4 and R is a rare-earth element such as Gd. The insulator layer 76 covers the guard rings 72, but not the junction barrier control rings 74.

A voltage blocking layer contact 80 and substrate contact 60 are formed respectively on the voltage blocking layer 70 and the substrate 10. The substrate contact 60 in one embodiment is an n-type contact (contacting an n-type layer) and may comprise a sequence of layers such as a Ti/Al/Ti/Au, Ti/Al/Ni/Au, or Ti/Al/Pt/Au stack, wherein each layer is between about 10 and about 500 nm thick. The deposition of the substrate contact 60 may be achieved, for example, by electron beam evaporation, thermal evaporation, or other techniques. In one embodiment, the first Ti layer is between 10 and 30 nm thick, the Al layer between 50 and 300 nm thick, and the outermost layers of the contact 60 between 30 and 70 nm thick.

Following the deposition of the contact 60, the structure is annealed at a temperature between about 500 °C and 950 °C in one embodiment, between about 750 and 870° C in another embodiment, in order to achieve an ohmic contact.

Suitable compositions for the voltage blocking layer contact 80 include Ti/Pt/Au, Ni/Au and Pt/Au stacks, wherein the first layer(s) is(are) between about 20 and 200 nm and the Au layer is between about 100 and 1000 nm thick. After the voltage blocking layer contact 80 is formed, the device structure is not annealed at high temperature, so as to retain Schottky contact characteristics.

Figure 9 illustrates another embodiment of the invention, where the device is a p-i-n rectifier. The device structure of the p-i-n rectifier of Figure 9 is similar to that of the Schottky rectifier of Figure 8 described above. Optionally, the p-i-n rectifier of Figure 9 also includes guard rings on the voltage blocking layer 70 and an insulating layer analogous to those in Figure 8. Contact layer 90 is formed directly on the voltage blocking layer 70. The contact layer 90 may comprise, for example, p-GaN. The contact layer 90 may have a thickness, for example, of between about 100 and 1000 nm in one embodiment, and between about 300 and about 700 nm in another embodiment. The contact layer 90 may have a carrier concentration greater than about 2×10¹⁸ cm⁻³.

The p-i-n rectifier of Figure 9 also includes a substrate contact 60 in a similar fashion to the device of Figure 8, which may be an n-type contact. The p-i-n rectifier of Figure 9 also includes an ohmic contact layer contact 92.

Suitable compositions for the contact layer contact 92 include, for example, Ni/Au and Pt/Au stacks, wherein the first layer is between about 20 and 200 nm and the Au layer is between about 100 and 1000 nm thick. Following the depositions of the substrate contact 60 and the contact layer contact 92, the structure is annealed at a temperature between about 500 °C and 950 °C, or preferably between about 750 and 870° C, in order to achieve ohmic contacts.

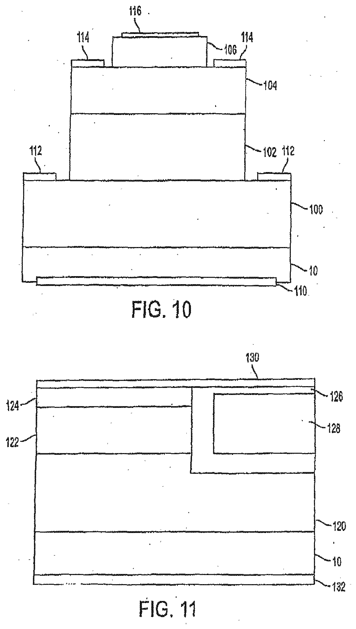

Figure 10 illustrates another embodiment of the invention where the device is a thyristor. The thyristor can be fabricated in either a npn(N)p configuration, or a pnp(P)n configuration. For simplicity, fabrication of only the npn(N)p configuration will be described in detail but fabrication of the pnp(P)n configuration is directly analogous. The pnp(P)n configuration may be formed by substituting the p-type layers with a corresponding n-type layer of the npn(N)p configuration and vice versa.

The thyristor of Figure 10 includes a GaN substrate 10. The GaN substrate 10 may be semi-insulating, with a resistivity greater than 10 Ω-cm, or may be n-type, preferably with a carrier level greater than about 2×10¹⁸ cm⁻³.

A voltage blocking layer 102 is formed over the substrate 10. The voltage blocking layer 102 may be an undoped layer of Al*ₓ*In*_{y}*Ga_{1-*x*-*y*}N, wherein 0 ≤ *x*, *y* ≤ 1, 0 ≤ x + *y* ≤ 1, with a thickness between 1 and 500 µm in one embodiment, and between 50 and 200 µm in another embodiment. The voltage blocking layer 102 has greater thickness for higher blocking voltage requirements. The carrier concentration in the voltage blocking layer 102 is preferably low, for example below 5×10¹⁶ cm⁻³ and in another example, below 10¹⁵ cm⁻³.

In the case where substrate 10 is semi-insulating, a first doped layer 100 may be optionally formed between the substrate 10 and the voltage blocking layer 102. The first doped layer 100 may be a n doped GaN layer deposited on the substrate 10, with a thickness between about 0.2 and 5 µm in one embodiment, and between about 1 and 2 µm in another embodiment, and a carrier concentration greater than about 2×10¹⁸ cm⁻³. If the bulk GaN substrate 10 is semi-insulating, doped layer contacts 112 are made on the top surface of the first doped layer 100. The first doped layer 100 may be used to improve the performance of the ohmic contact of the contacts to the substrate 10 and, in the case of a semi-insulating substrate, to provide an electrical contact.

A second doped layer 104 is formed on the voltage blocking layer 102. The second doped layer 104 may comprise, for example, n-type Al*ₓ*In*_{y}*Ga_{1-*x*-*y*}N, wherein 0 ≤ *x, y* ≤ 1, 0 ≤ *x* + *y* ≤ 1, with a thickness between 100 nm and 3000 nm in one embodiment, and between 500 and 700 nm in another embodiment. The second doped layer 104 may have a carrier concentration of about 2×10¹⁷ cm⁻³. The second doped layer 104 may comprise n-GaN. Optionally, a n-Al*ₓ*Ga_{1-*x*}N/GaN superlattice may be deposited on the top surface of the second doped layer 104.

A cap layer 106 is formed on the second doped layer 104. The cap layer 106 may comprise p⁺-GaN, and may have a thickness of about 500 nm and a carrier concentration greater than about 2×10¹⁸ cm⁻³.

Doped layer contacts 112, voltage blocking layer contacts 114 and cap layer contact 116 are formed on respectively the first doped layer 100, second doped layer 104 and cap layer 106. The layers may be etched as appropriate to expose the appropriate layers. A bottom contact 110 may be deposited on the back surface of the substrate 10, for example, if the bulk GaN substrate 10 is n⁺-type.

Suitable compositions for the n-type contacts (contacts on n-type layers) include Ti/Al/Ti/Au, Ti/Al/Ni/Au, and Ti/Al/Pt/Au stacks, wherein each stack layer is between about 10 and about 500 nm thick, and deposition may be achieved by techniques known in the art including electron beam evaporation, thermal evaporation, or other techniques. In one embodiment, the first Ti layer is between 10 and 30 nm thick, the Al layer between 50 and 300 nm thick, and the outermost layers between 30 and 70 nm thick. Suitable compositions for the p-type contacts (contacts on p-type layers) include Ni/Au and Pt/Au stacks, wherein the first layer of the stack is between about 20 and 200 nm and the Au layer is between about 100 and 1000 nm thick. Following the depositions the structure is annealed, at a temperature between about 500 °C and 950 °C, or preferably between about 750 and 870° C, in order to achieve ohmic contacts for the contact layers.

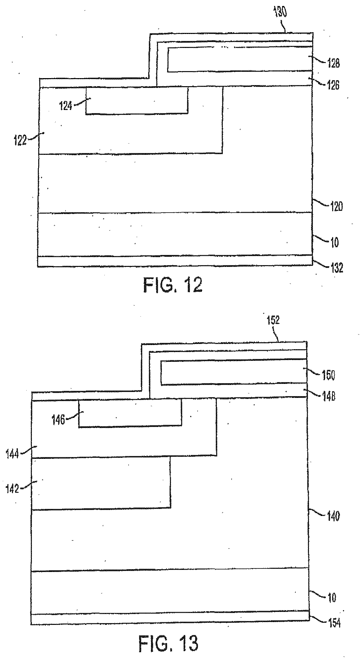

Figures 11 and 12 illustrate two other embodiments of the invention where the devices are power vertical MOSFETs or MISFETs (MOSFET for devices with a gate oxide, and MISFET for devices with a gate insulating layer). Figure 11 illustrates a UMOSFET / UMISFET, while Figure 12 illustrates a DMOSFET / DMISFET. The "U" in UMOSFET or UMISFET refers to the shape of the trench structure where the gate is located. The "D" in DMOSFET or DMISFET refers to the diffusion or doubly-implanted layers in the structure. The MOSFET/ MISFET vertical structure is similar in operation to a lateral MOSFET/ MISFET device, but the current flow is directed vertically through the substrate in the vertical structure. The descriptions of UMOSFETs and DMOSFETs below involve npn-type structures, but analogous devices with pnp structures are also possible.

Referring again to the UMOSFET of Figure 11, the device includes a GaN substrate 10. The GaN substrate 10 may be n-type, for example. A voltage blocking layer 120 is formed over the substrate 10 and may be, for example, n-type with a carrier concentration of about 1×10¹⁷ to 5×10¹⁶ cm⁻³. The voltage blocking layer 120 may be, for example, GaN, and may have a thickness, for example, of greater than about 400 nm.

A p-type channel layer 122 is formed over the voltage blocking layer 120. The p-type channel layer 122 may be, for example, p-doped to a carrier concentration of about 2×10¹⁷ cm⁻³. The p-type channel layer 122 may be, for example, GaN, and may have a thickness, for example, of between about 100 and 200 nm.

A n-type source layer 124 is formed over the p-type channel layer 122. The n-type source layer 124 may be, for example, GaN.

A trench may be etched into voltage blocking layer 120, p-type channel layer 122 and n-type source layer 124 to allow for formation of the gate insulator 126 and metal gate 128. The trench may be formed by plasma etching, for example.

After the trench is etched, part of the gate insulator 126 is formed in the trench. The gate insulator 126 material may be, for example, an oxide such as at least one of SiO₂, SC₂O3, MgO, Ga₂O₃, and R₂O₃, where R is a rare-earth element such as Gd.

Suitable compositions for a non-oxide gate insulator 126 include A1N, SiNₓ, and Si₃N₄, where *x* is between 0 and 1.4. The metal gate 128 is then deposited into the trench on the gate insulator 126, then overcoated with oxide or non-oxide insulating material to form some of the gate insulator 126 over the metal gate 128 except above one or more points (not shown) where electrical contacts are made to the metal gate 128. A source contact 130 is then formed over the n-type source layer 124, while a bottom contact 132 is formed on the back surface of the substrate 10.

Suitable compositions for contacts 130 and 132 include Ti/Al/Ti/Au, Ti/Al/Ni/Au, and Ti/Al/Pt/Au stacks, wherein each stack layer is between about 10 and about 500 nm thick, and deposition is achieved by known techniques including electron beam evaporation, thermal evaporation, and the like. In one embodiment, the first Ti layer is between 10 and 30 nm thick, the Al layer between 50 and 300 nm thick, and the outermost layers between 30 and 70 nm thick. Following the depositions the structure is annealed, at a temperature between about 500°C and 950°C in one embodiment, between about 750 and 870°C in another embodiment, in order to achieve ohmic contacts for the contact layers.

Figure 12 illustrates a DMOSFET device structure. The DMOSFET is similar to the UMOSFET, however, the gate insulator 126 and the metal gate 128 are not formed in a trench, but over the p-type layer 122 and n-type layer 124. Furthermore, in the DMOSFET device structure, the p-type layer 122 and n-type layer 124 may be formed in the voltage blocking layer 120 using selective area ion implantation, diffusion doping, or, alternatively, epitaxy followed by etching, additional epitaxy, and re-planarization.

In the DMOSFET the gate insulator 126 and the metal gate 128 act to modulate the portion of the channel layer 122 under the gate. Current flows laterally from source 124 through channel 122 and then vertically through voltage blocking layer 120 to bottom contact 132. For both the UMOSFET and the DMOSFET, the voltage blocking layer supports the blocking voltage under normally off conditions. This vertical device structure greatly benefits from the absence of a band offset and voltage drop at the epi/substrate interface of the homoepitaxial device structure compared to a heteroepitaxial structure. In addition, the reduced dislocation density in the homoepitaxially grown voltage blocking layer 120, and resulting longer carrier lifetime gives rise to a conductivity modulation of the voltage blocking layer which will lower the overall power loss of the device.

Figure 13 illustrates another embodiment of the invention where the device is a power Insulated Gate Bipolar Transistor (power IGBT). The power IGBT can be fabricated in either n⁺-p-n-p⁺ or p⁺-n-p-n⁺ configuration, but for simplicity will only be described in detail as n⁺-p-n-p⁺. Fabrication of the p⁺-n-p-n⁺ is directly analogous, with the p-doped layers being substituted for n-doped layers and vice versa. The operation and fabrication of the power IGBT is similar to that of the power lateral DMOSFET of the embodiment of Figure 12. In the power IGBT, however, the substrate is of the opposite polarity to the blocking layer, effectively making a DMOSFET in series with a p-i-n junction diode such that the device will only conduct current in one direction.

The power IGBT includes a p-type substrate 10, an n-type voltage blocking layer 140 formed on the p-type substrate 10, a heavily doped p-type base layer 142 formed in and over the blocking layer 140, a lightly doped p-type base layer 144 formed in and over the blocking layer 140, and over the heavily doped p-type base layer 142, and an n-type emitter 146 formed in the lightly doped p-type base layer 144. A gate insulating layer 148 is formed over the doped layer and partially surrounds a metal gate 150. Finally an emitter contact 152 is formed over and contacting the emitter 146, and a bottom contact 154 is formed on the reverse side of the substrate 10.

The substrate may be p-doped GaN. The voltage blocking layer 140 may be n-doped GaN, for example, with a doping concentration of about 1×10¹⁶ to 5×10¹⁶ cm⁻³, and with a thickness of greater than about 400 nm. The heavily doped p-type base layer 142 may be, for example, GaN with a doping concentration of about 2×10¹⁸ cm⁻³, and with a thickness of between about 100 and 200 nm. The lightly doped p-type base layer 144 may be, for example, GaN with a doping concentration of about 2×10¹⁷ cm ³, and with a thickness of between about 100 and 200 nm. The n-type emitter 146 may be, for example, GaN with a doping concentration of about 1×10¹⁸ cm⁻³, and with a thickness of between about 50 and 100 nm. The gate insulator 148 material may be, for example, an oxide such as at least one of SiO₂ Sc₂O₃, MgO, Ga₂O₃, and R₂O₃, where R is a rare-earth element such as Gd. Suitable compositions for a non-oxide gate insulator 148 include AlN, SiN*ₓ*, and Si₃N₄, where *x* is between 0 and 1.4. The metal gate 150 may be, for example, Mo. Suitable compositions for the emitter contact 152 include Ti/Al/Ti/Au, Ti/Al/Ni/Au, and Ti/Al/Pt/Au stacks, wherein each layer of the stack is between about 10 and about 500 nm thick, and deposition is achieved by electron beam evaporation, thermal evaporation, or other techniques. In one embodiment, the first Ti layer is between 10 and 30 nm thick, the Al layer is between 50 and 300 nm thick, and the outermost layers between 30 and 70 nm thick. Suitable compositions for the bottom contact 154 include Ni/Au and Pt/Au stacks, wherein the first layer is between about 20 and 200 nm and the Au layer is between about 100 and 1000 nm thick. Following the depositions the structure is annealed, at a temperature between about 500 °C and 950 °C in one example, or between about 750 and 870° C in another example in order to achieve an ohmic contact.

The n-type emitter layer 146, the lightly doped p-type base layer 144 and the heavily doped p-type base layer 142 may be created using selective area ion implantation, diffusion doping, or, alternatively, epitaxy followed by etching a trench, epitaxial filling of the trench, and re-planarization, for example. The heavily doped p-type base layer 142 may be used to suppress latch-up of the parasitic thyristor inherent to the device structure. The n-type voltage blocking layer 140 will have a thickness and doping concentration that varies according to the blocking voltage desired. Like the DMOSFET and UMOSFET described above, this vertical device structure greatly benefits from the higher conductivity of the bulk GaN substrate. In addition, the reduced dislocation density in the homoepitaxially grown blocking layer, and resulting longer carrier lifetime gives rise to a conductivity modulation of the drift region which will lower the overall power loss of the device.

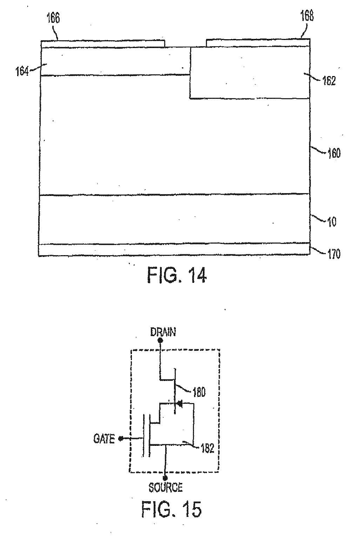

Figure 14 illustrates another embodiment of the invention, where the device is a power vertical JFET. The power vertical JFET includes a n-type substrate 10, a lightly doped n-type voltage blocking layer 160 formed on the n-type substrate 10; a heavily doped n-type source layer 164 formed over the blocking layer 160, a p-type gate layer 162 formed in and over the blocking layer 160. A source contact layer 166 is formed on the source layer 164. A gate contact layer 168 is formed on the gate layer 162. Finally, a drain contact 170 is formed on the reverse side of the substrate 10.

In the vertical JFET structure, the current flow is directed vertically from the source layer 164 through the blocking layer 160 through substrate 10. This device is a normally-on device. It is turned off by applying a negative bias to the pn junction between the source and gate layers 164 and 162. With sufficient reverse bias on the pn junction, the depletion layer expands below the source layer 164 and pinches off the channel, preventing vertical current flow. This structure consists of a buried channel where issues of surface traps and insulating layers are minimized. The large critical field of GaN allows this structure to have a high blocking voltage with low on-state resistance. Also, this device is a unipolar majority carrier device and is capable of high switching speed due to the absence of stored minority charge. This device can be designed to be normally off by reducing the width of source layer 164 to below approximately 1 micron such that the built-in depletion region extending from gate layer 162 pinches off the channel under source layer 164.

In the device, the substrate may be n-type GaN. The voltage blocking layer 160 may be n-type GaN, for example, with a doping concentration of about 1×10¹⁶ to 5×10¹⁶ cm , and with a thickness of greater than about 5000 nm. The source layer 164 may be, for example, n-type GaN with a doping concentration of about 1×10¹⁸ cm⁻³, and with a thickness of between about 100 and 500 nm. The gate layer 162 may be, for example, p-type GaN with a doping concentration of greater than about 5×10¹⁷ cm⁻³, and with a thickness of between about 750 and 2000 nm. The source contact 166 may be, for example, Ti/Al/Ti/Au. The gate contact 168 may be, for example, Ni/Au. The drain contact 170 may be, for example, Ti/Al/Ti/Au. The thickness and doping values are for a blocking voltage on the order of 1000V. In general, the doping and thickness values would depend on the desired blocking voltage characteristic.

The blocking layer 160 and source layer 164 may be grown epitaxially in one embodiment, while the gate layer 162 may be formed by implanting with a p-type implant species (such as Mg) into the blocking layer 160 and source layer 164. Alternatively, the gate layer 162 may be formed by epitaxially re-growth after trench etching of the region where the gate layer 162 is to be grown and then planarized to smooth the top surface.

The above described normally-on power vertical JFET can be combined with a low voltage FET in a cascode configuration making a normally-off circuit that is voltage controlled. Figure 15 illustrates a GaN vertical JFET 180 in cascode with a low-voltage discrete silicon MOSFET 182. Alternatively, 182 may instead constitute a discrete SiC or a GaN based low-voltage normally-off FET.

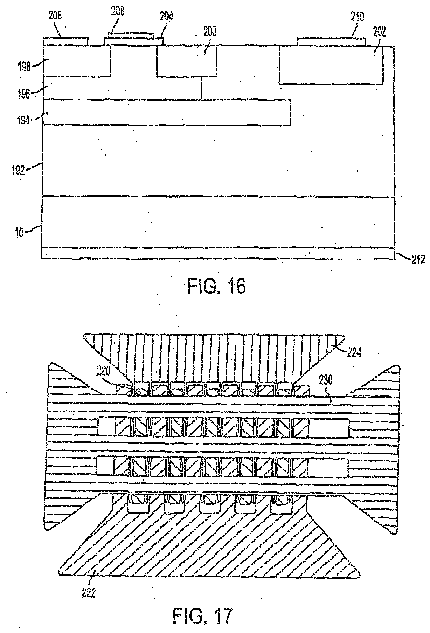

Figure 16 illustrates another embodiment of the invention demonstrating an integrated approach to the cascode configuration, where a low voltage GaN normally-off FET is integrated as a part of the structure on the same substrate with a vertical JFET. The integrated structure includes a substrate 10, a n-type blocking layer 192 formed over the substrate 10, a buried p-type gate layer 194 formed in the blocking layer 192, a p-type well layer 196 formed on the buried gate layer 194, n-type source 198 and n-type drain 200 formed in the well layer 196, and a p-type field stop 202 formed in the blocking layer 192 and lateral to the n-type source 198 and n-type drain 200. The device also includes a source contact 206 on the source 198, a gate contact 208 on an insulating layer 204 which is on the channel region in well layer 196 between the source 198 and drain 200, a field stop contact 210 on the field stop 202 and a drain contact 212 on the reverse side of the substrate 10.

In the integrated structure, the substrate may be n-type GaN. The blocking layer 192 may be n-type GaN, for example, with a doping concentration of about 1×10¹⁶ to 5×10¹⁶ cm⁻³, and with a thickness of greater than about 5000 nm. The buried gate layer 194 may be p-type GaN, for example, with a doping concentration of about 1×10¹⁹, and with a thickness of between about 100 and 500 nm. The well layer 196 may be p-type GaN, for example, with a doping concentration of about 1×10¹⁷, and with a thickness of between about 500 and 2000 nm. The field stop layer 202 may be p-type GaN, for example, with a doping concentration of about 1×10¹⁹, and with a thickness of between about 100 and 500 nm. The source and drain 198 and 200 may be n-type GaN, for example, with a doping concentration of about 1×10¹⁹; and with a thickness of between about 100 and 500 nm. The insulating layer 204 may be an oxide, or other insulating layer, for example. Suitable compositions for the source contact 206 and drain contact 212 include Ti/Al/Ti/Au. Suitable compositions for gate contact 208 and field stop contact 210 include Ni/Au.

The devices described in the above embodiments may be discrete, for example for HBT, Schottky rectifier, p-i-n rectifier, thyristor, or vertical MOSFET or JFET devices, or they may consist of arrays, for example for the HEMT, MESFET, and MOSFET/MISFET devices.

An example of a HEMT array is shown in Figure 17. The array device includes gate contacts 224, drain contacts 222, and source contacts 220. External electrical connection to the array of source contacts is made by means of air bridges 230, which are bonded to source contacts 220, but pass over drain contacts 222 and gate contacts 224 without making any electrical contact. The array device includes an active region (not shown) below the contacts, where the array device includes a number of HEMT components in an array.

With respect to embodiments encompassing homoepitaxial light-emitting diode devices or LEDs, references are made to Figure 18, which is a detailed schematic illustration of the structure of one embodiment of a homoepitaxial LED. The GaN wafer 4 is shown as the substrate upon which the device is formed. The device structures 6, 8, 10, and 12 are formed by decomposition of organometallic precursors in an ammonia-containing atmosphere on the substrate 4 surface. A carrier gas, such as hydrogen or helium, may be used. Suitable organometallic precursors include trimethylgallium, trimethylaluminum, trimethylindium, and mixtures thereof. Suitable dopant precursors include silane for n-type material, and bis-(cyclopentadienyl) magnesium or dimethyl zinc, for p-type material.

After the substrate 4 has been annealed, as described above in [0152], a cladding layer of n-type GaN or AlᵤInᵥGa₁₋ᵤ₋ᵥN, where 0 ≤ *u, v, u*+*v* ≤ 1, 6 is optionally formed on the surface of the substrate 4. The n-type GaN or AlᵤInᵥGa₁₋ᵤ₋ᵥN cladding layer 6 has a thickness between about 1 nm and 10 µm in one embodiment, and between about 0.1 and 4 µm in another embodiment. The deposition of the n-type GaN or AlᵤInᵥGa₁₋ᵤ₋ᵥN cladding layer 6 may lead to improved electrical properties relative to the substrate itself, a different doping level and electrical conductivity, a higher bandgap, or combinations thereof.

The active layer 8 is then deposited on the optional n-type GaN or AlᵤInᵥGa₁₋ᵤ₋ᵥN 6 or the substrate 4, in the absence of the n-type GaN or AlᵤInᵥGa₁₋ᵤ₋ᵥN 6 layer. The active layer 8 comprises Al_{w}InₓGa_{1-w-x}N, where 0 ≤ *w, x, w*+*x* ≤ 1 and, in one embodiment, at least one of w and *x* are nonzero. For w = 0, as *x* varies from 0 to 1, the bandgap varies between 3.4 and 0.8 eV, allowing for light emission between the ultraviolet and red regions of the electromagnetic spectrum. The composition of the cladding layer is chosen so that its band gap is larger than that of the active layer. Typically, *x* will lie between about 0.025 and 0.6. More particularly, *x* is between about 0.05 and 0.5. Typically *w*<0.05.

The active layer may be undoped, n-type doped with impurities such as Si or Ge, or p-type doped, with impurities such as Zn or Mg. It may comprise a single layer, as in so-called double heterostructure or single quantum-well structures, or it may comprise a superlattice of Al_{c}In_{d}Ga_{1-c-d}N/ AlₑIn_{f}Ga_{1-e-f}N, where 0 ≤ *c*, *d, e, f, c*+*d, e*+*f* ≤ 1, or In_{d}Ga_{1-d}N and In_{f}Ga_{1-f}N, where 0 ≤ *d* ≤ *f,* in so-called multiple-quantum well structures. In one embodiment, the superlattice comprises about 1-50 alternating layers of the two different compositions of AlInGaN, with the more In-rich/Al-poor layers (lower bandgap) comprising the well and the less In-rich/Al poor layers (higher bandgap) comprising the barrier. Each individual layer may have a thickness between about 0.5 and 50 nm. The well and barrier layers may be undoped, n-type, or p-type doped. In one embodiment, the structure comprises undoped well layers, and n-type doped or undoped barrier layers. InN and Al_{c}In_{d}Ga_{1-c-d}N decompose at a temperature lower than does GaN. In an embodiment, these layers are deposited at temperatures between about 500 and 1200 °C. In a second embodiment, between about 650°C and 1050°C.

In an embodiment wherein the active layer is n-type doped, and relatively thick, between about 50 and 500 nm, the LED is a double-heterostructure device, particularly if the n-type cladding layer 6 comprised AlᵤInGa₁₋ᵤ₋ᵥN rather than GaN. In another embodiment wherein the active layer is undoped and relatively thin, e.g., 1 to 10 nm, the LED device is a single quantum well, particularly if at least one additional n- AlᵤInᵥGa₁₋ᵤ₋ᵥN cladding layer is positioned between the n-GaN layer 6 and the active layer 8.

In one embodiment, one or more cladding layers are optionally disposed around the active layer 8. As seen in Figure 18, cladding layer 10 comprises a p-type cladding layer. The cladding layer 10 comprises p-Al_{y}In_{z}Ga_{1-y-z}N, wherein 0 ≤ *y, z, y*+*z* ≤ 1. The cladding layer 10 has the property of a larger bandgap than that of the active layer 8, and is useful for confining the electrical carriers and, in the case of laser diodes, of favorably directing light emission in the desired directions via optical confinement.

In one embodiment, the cladding layers 6 and 10 are deposited at temperatures between about 600 and 1500 °C. In another embodiment, between about 850 and 1200 °C. In one embodiment, at least one cladding layer is comprised of a Al_{y}In_{z}Ga_{1-y-z}N superlattice. The use of a superlattice helps manage lattice strain and, particularly in the case of the p-cladding layer, increases the electrical conductivity.

Above the p-doped cladding layer, one or more p-contact layers 12 is optionally deposited. In one embodiment, the p-contact layer 12 comprises p-GaN. In another embodiment, advantageous for current-spreading, the p-contact layer comprises a p⁺-Al_{y}In_{z}Ga_{1-y-z}N superlattice. In another embodiment, the p-contact layer comprises a p⁺-Al_{y}In_{z}Ga_{1-y-z}N -to-n⁺-Al_{y}In_{z}Ga_{1-y-z}N tunnel junction. In yet another embodiment, a tunnel junction is combined with at least one of a p⁺-Al_{y}In_{z}Ga_{1-y-z}N superlattice and a n⁺-Al_{y}In_{z}Ga_{1-y-z}N superlattice. In still another embodiment, the p-contact layer comprises at least one metal oxide MO*ₓ*, where 0 < *x* ≤ 2 and the metal M comprises at least one of indium, tin, zinc, gold, silver, copper, and nickel.

One common impurity in GaAlInN devices is hydrogen. In the case of p-type material, the hydrogen may complex with acceptor centers and cause the resistivity to be high, degrading device performance. The hydrogen-acceptor complexes may be dissociated in the present invention by annealing at a temperature above about 400 °C, or their formation may be avoided in the first place by use of a hydrogen-free growth environment, such as argon, nitrogen, or vacuum. In an embodiment with the absence of hydrogen, the resistivity of the p-type layers is kept be below about 10⁵ Ω-cm, or in another embodiment, below about 10 Ω-cm.

In one embodiment of the formation of the light emitting diode devices of the present invention, metallic and/or conductive-oxide contacts 14, 16 are formed on the top (p-type) and bottom (n-type) surfaces. Most of the area of the p-type contact 16 is very thin, about 0.001 to about 1 µm thick, so as to be substantially optically transparent. Suitable compositions for the p-type contact 16 include nickel-gold, or at least one metal chosen from Pd, Pt, Ag, Au, Al, Sn, In, Cr, Ti, and mixtures thereof. A conductive-oxide contact comprises at least one of indium oxide, tin oxide, and zinc oxide, or combinations thereof. The nickel-gold p-type contact 16 may be alloyed or may contain a nickel-rich composition in contact with the p-GaN layer 12, and a gold-rich composition in contact with the nickel-rich layer.

One suitable composition for the n-type contact 14 is titanium-aluminum. The titanium-aluminum n-type contact 14 may be alloyed or may contain a titanium-rich composition in contact with the n-GaN substrate 14 and an aluminum-rich composition in contact with the titanium-rich layer. Alternatively, the n-type contact 14 may be formed using at least one of Al, Sc, Ti, Zr, Mo, Ta, W, Ni, Cu, Ag, Au, Pd, Pt, Hf, a rare earth metal, and mixtures thereof. The contacts 14, 16 may be deposited by any means known in the art including sputter-deposition, thermal evaporation, or e-beam evaporation. In one embodiment, the metal contacts 14, 16 will perform as ohmic contacts if annealed to a temperature between about 400 and 950 °C.

Optionally, to aid in separation of the wafer into individual LED dies and to improve device lifetime, a mesa is etched through the device structure around the periphery of the device and a passivation layer 18 deposited on the lateral surfaces of the mesa. The passivation layer may comprise SiO₂ or SiN*ₓ* and may be deposited by thermal evaporation, e-beam evaporation, sputtering, chemical vapor deposition, plasma-enhanced chemical vapor deposition, or the like.

Due to the high quality of the substrate, the homoepitaxial light-emitting device is free of tilt boundaries and, for a device area up to about 10⁴ µm², or up to about 9×10⁴ µm², or up to 1 mm², most devices are substantially free of threading dislocations.

With reference to Figure 19, an alternative embodiment of a homoepitaxial LED structure of the present invention is shown. While a vertical LED structure (Figure 18) makes more efficient use of substrate area, a lateral configuration with two topside contacts is advantageous in some applications, for example, flip-chip bonding. In this embodiment, the GaN substrate 4 may be n-type, semi-insulating, or p-type, although for purposes of illustration only the substrate is assumed to be n-type. An n-contact layer 20 comprising n-GaN or n-AlᵤInᵥGa₁₋ᵤ₋ᵥN, where 0 ≤ *u, v*, *u*+*v* ≤ 1, is deposited on the substrate followed by, optionally, one or more n-AlᵤInᵥGa₁₋ᵤ₋ᵥN cladding layers 6. Active layer 8, comprising Al_{w}InₓGa_{1-w-x}N, where 0 ≤ *w*, *x, w*+*x* ≤ 1 and in one embodiment, at least one of *w* and *x* are nonzero, is then deposited. As above, the active layer may comprise a double heterostructure, a single quantum well, or a Al_{c}In_{d}Ga_{1-c-d}N/ AlₑIn_{f}Ga_{1-e-f}N multiple quantum well, where 0 ≤ *c*, *d, e, f c*+*d, e*+*f* ≤ 1. Next to be deposited, optionally, are one or more p-GaN or p-Al_{y}In_{z}Ga_{l-y-z}N, wherein *0 ≤ y, z, y*+*z* ≤ 1, cladding layers 10 and a p-GaN or p-Al_{y}In_{z}Ga_{1-y-z}N p-contact layer 12. A mesa is then etched through a portion of the layers so as to expose a portion of the n-contact layer 20. The n-electrode 14 and p-electrode 16 are then deposited as described above and, optionally, passivation layer 18 is applied to the exposed mesa.

In one embodiment, the substrate is doped with at least one luminescent atom or color center, for example, at least one of a transition or rare-earth metal such as Ti, V, Cr, Mn, Fe, Co, Ni, Zr, Hf, Pr, Eu, Er, or Tm. In another embodiment, a homoepitaxial layer of GaN containing at least one luminescent atom or color center is deposited on the gallium nitride substrate, the active layer, one of the cladding layers, or on the backside of the substrate. The homoepitaxial layer is deposited by methods that are well known in the art, such as molecular beam epitaxy or metalorganic chemical vapor deposition. In one embodiment, the dopant or color center is present at a concentration of at least 10¹⁷ cm⁻³ and emits or produces luminescence at least one wavelength between 300 and 1000 nm. In this embodiment, a portion of the light emitted by the active layer is absorbed by the at least one luminescent atom or color center in the substrate, producing an electronically excited state. The excited state then relaxes, emitting light of a different color. In this way the light emitting diode can emit light at two or more different wavelengths without the use of a separate phosphor. For example, red-luminescing GaN crystals can be synthesized by doping with Eu. Combination of blue, blue-green, or green light emitted by the active layer of the light emitting diode and red, orange, yellow, and/or green light emitted by the substrate can produce white light. In another embodiment, luminescence is provided by a second substrate that is wafer-bonded to the backside of the gallium nitride substrate by methods that are well known in the art. Examples of such a second substrate include ruby (Ti-doped sapphire) and cerium-doped yttrium aluminum garnet.

With reference to Figure 20, which is a detailed schematic illustration of a structure representative of a homoepitaxial laser diode device of the present invention. The initial steps in the formation of a laser diode device 18 are the same as those of forming the light emitting diode device 12 as described above. Figure 20 shows a laser diode including many of the optional components discussed with reference to Figure 18. Specifically, the laser diode 18 comprises a n-GaN substrate upon which the LD semiconductor device is disposed. For illustration purposes, a vertically oriented device is shown in Figure 20. A laterally oriented device analogous to the device shown in Figure 19 is also within the scope of the present invention.

The first layer disposed on the n-GaN substrate 4 in Figure 19 is an n-type cladding layer of the structure n-AlₐIn_{b}Ga_{1-a-b}N 6, followed by an optional n-Al_{c}In_{d}Ga_{1-c-d}N light-guiding layer 20, where 0 ≤ *a*, *b, c, d, a*+*b, c*+*d* ≤ 1. Cladding layer 6 may comprise a n-AlₐIn_{b}Ga_{1-a-b}N superlattice. The active layer depicted in the Figure is an AlₑIn_{f}Ga_{1-e-f}N/ Al_{g}InₕGa_{1-g-h}N multiple quantum well layer of the super lattice structure described above, where 0 ≤ *e, f, g, h, e*+*f, g*+*h* ≤ 1. Disposed on the active layer 22 is a p-AlᵢInⱼGa₁₋ᵢ₋ⱼN blocking layer 24, followed by a p-AlₖInₗGa₁₋ₖ₋ₗN light-guiding layer 26 and a p-AlₘInₙGa₁₋ₘ₋ₙN cladding layer 10, where 0 ≤ *i, j, k, l, m, n, i+j, k*+*l, m*+*n ≤* 1. In one embodiment, cladding layer 10 comprises a p-AlₘInₙGa₁₋ₘ₋ₙN superlattice. In another embodiment, each of cladding layers 6 and 10, light-guiding layers 20 and 26, and p-type blocking layer 24 have a bandgap greater than that of active layer 22. In yet another embodiment, optical guiding layers 20 and 26 have bandgap that is smaller than that of cladding layers 6 and 10, and p-type blocking layer 24 has a bandgap that is greater than those of cladding layers 6 and 10. The final layer is an optional p-AlₒInₚGa₁₋ₒ₋ₚN contact layer 12 which has a bandgap larger than that of active region 22 but smaller than that of cladding layer 10, where 0 ≤ *o*, *p*, *o*+p ≤ 1.

As described above, the contact layer 12 may alternatively comprise at least one of a p⁺-Al_{y}In_{z}Ga_{1-y-z}N superlattice, a p⁺-Al_{y}In_{z}Ga_{1-y-z}N -to-n⁺-Al_{y}InGa_{1-y-z}N tunnel junction, where 0 ≤ *y, z, y*+*z* ≤ 1, and at least one metal oxide MO*ₓ*, where 0 < *x* ≤ 2 and the metal M comprises at least one of indium, tin, zinc, gold, silver, copper, and nickel.

In order to provide lateral confinement of the laser cavity, the p-contact layer, cladding layers, active layer and, optionally, the n-contact layer are etched through the device structure to form a mesa structure. The mesa is deep enough to extend at least below the active layer, and may extend all the way into the uppermost portion of the substrate. In one embodiment, the width of the stripe-shaped mesa is between about 2 µm and about 500 µm. In a second embodiment, between about 5 µm and about 25 µm.

In order to improve the electrical confinement and decrease the threshold current, a ridge structure may be etched through the periphery of the contact layer 12 and into the uppermost cladding layer 10, as shown in Figure 20. The width of the ridge is between about 1 and about 10 µm, and its boundary is preferably at least 3 µm away from the edge of the stripe mesa, and even more preferably at least 10 µm away from the edge of the stripe mesa in order that any lattice damage associated with formation of the mesa structure may not reduce the efficiency of light emission by the active layer. Normally, the ridge structure will be formed prior to etching of the mesa structure since it is shallower. Following etching to form the stripe mesa and ridge structure, the side surfaces of the mesa and ridge, but not the top of the ridge, are passivated by means of passivation layer 18. The passivation layer may comprise SiO₂ or SiN*ₓ* and may be deposited by thermal evaporation, e-beam evaporation, sputtering, or the like. Optionally, passivation layer 18 may be deposited after top metallic contact 16.

As shown, metallic contacts 14, 16 are formed on the top (p-type) and bottom (n-type) surfaces. A suitable composition for the p-type contact 16 is nickel-gold, either alloyed or with a nickel-rich composition in contact with the p-GaN layer 12 and a gold rich composition in contact with the nickel-rich layer. A suitable composition for the n-type contact 14 is titanium-aluminum, either alloyed or with a titanium-rich composition in contact with the n-GaN substrate 4 and an aluminum-rich composition in contact with the titanium rich layer. The contacts may be deposited by any means known in the art, e.g., sputter-deposition or e-beam evaporation. In one embodiment, the contacts will perform as ohmic contacts if annealed to a temperature between about 400 °C and 950 °C.

The final step in preparation of the laser diode device structure is to cut the device in a plane perpendicular to the stripe/ridge structure in order to define the long dimension of the laser cavity. In one embodiment, the length of the laser structure is between 100 µm and 2000 µm. In another embodiment, between about 400 µm and 1000 µm. The simplest method for forming reflective surfaces on the edges of the device is to cleave the substrate and device structure, optionally polish, and finally deposit a reflective film on the facets to increase the reflectivity.

In yet another embodiment, the device structures is grown such that the short (facet) dimension is parallel to a (101̅0) plane of the substrate 4. Following the completion of layer deposition, the wafer is cleaved along (101̅0) planes, which are perpendicular to the (0001) growth direction and cleave readily. In an alternative embodiment, the laser facets are prepared by reactive ion etching or a similar dry etch method. If desired to improve the surface finish, the facets can be mechanically polished by standard metallographic methods.

In one embodiment, a reflective coating on the facets comprises a distributed Bragg reflector (DBR) comprising several layers of alternating refractive index. Suitable compositions for the DBR include TiO₂/SiO₂ for wavelengths greater than about 390 nm, ZrO₂/SiO₂ for wavelengths greater than about 300 nm, or HfO₂/SiO₂ for wavelengths greater than about 230 nm, wherein the product of the thickness and index of refraction of each layer is an odd multiple of λ/4 in one embodiment, in another embodiment, equal to *λ*/4, where *λ* is the wavelength of desired operation of the laser diode. In one embodiment, the number of layers in the DBRs are chosen so that the reflectivity of the rear facet is greater than about 0.95 and the reflectivity of the front facet is between about 0.1 and about 0.5.

In each of the embodiments described in Figures 18-20, the substrate has been described as'n-type. However, in another set of embodiments, the substrate may be p-type and the n- and p-contact layers and the n- and p-cladding layers, respectively, are reversed.

It should be noted that modifications and alterations are within the scope of the invention, for example, while the detailed description is directed to a vertical device having top and bottom electrical contacts, an insulating or semi-insulating substrate could be used in conjunction with "side" contacts. In another example of alterations within the scope of the device of the invention for an LED, multiple stacks of LED structures may be incorporated into a single device, with each stack separated by a highly doped p⁺/n⁺ tunnel junction, e.g., a spreading layer based on a *p*⁺⁺/*n*⁺⁺ InGaN, GaN, or AlInGaN tunnel junction where the doping concentrations in the layers of the p⁺/n⁺ tunnel junction lie in the range of 10¹⁹ cm⁻³ or above. An LED with multiple stacks could be used to emit two or more wavelengths of light, for example.

Referring to an embodiment as depicted in Figure 25, of a prior art GaN / AlGaN on sapphire mesa p-i-n photodetector 10. Photodetector 10 comprises a sapphire substrate layer 11, an n-type AlGaN ohmic contact layer 12, an intrinsic GaN absorption layer 13, and a p-type GaN ohmic contact layer 14. A low-temperature AlN or GaN nucleation layer (not shown) typically separates sapphire substrate 11 from n-type AlGaN ohmic contact layer 12. The sapphire substrate layer 11 is transparent to the GaN absorption layers so it can detect the optical field from the backside. Layer 12 is comprises an n-type AlGaN layer and an n-type metal contact layer, such as Ti/Al/Ti/Au, which is deposited onto the AlGaN layer and annealed to form an ohmic contact. Layer 14 comprises a p-type AlGaN layer and a p-type metal layer, such as, but not limited to, Ni/Au, which is deposited onto the AlGaN layer and annealed to form an ohmic contact. The photodiode is operated by reverse biasing the junction. This is done by applying a positive voltage to the n-type metal contact layer 12. Under these conditions, the current is approximately independent of the voltage, but is proportional to the rate of optical generation of carriers. Layer 13 is the GaN intrinsic region where the photons are absorbed and generate electron/hole pairs that are drawn to opposites sides of the junction by the electric field where they then contribute to the detector current. Semiconductor layers 12, 13, and 14 typically contain a high concentration of threading dislocations, for example about 10⁹ - 10¹⁰ cm⁻², due to the lattice mismatch with the sapphire substrate.

Contrast to the prior art photodetector is Figure 26, which depicts an exemplary embodiment of a metal-semiconductor-metal (MSM) photodetector 100 of the invention. Photodetector 100 comprises a gallium nitride substrate 102, at least one active layer 104 disposed on the gallium nitride substrate 102, and at least one conductive contact structure 106 affixed to the at least one active layer 104. In one embodiment, at least one active layer 104 comprises -Ga_{1-*x-y*}Al*ₓ*In*y*N_{l-*z*-*w*}P_{z}As*_{w}*, wherein 0 ≤ *x, y, z, w ≤* 1,0 ≤ *x* + *y* ≤ 1, and 0 ≤ *z* + *w* ≤ 1. In another embodiment, at least one active layer 104 comprises Ga_{1-*x*}Al*ₓ*N, wherein 0 ≤ *x* ≤ 1.

The wafer used in the device is the gallium nitride wurtzite-type crystal structure of the present invention, which is substantially free of tilt boundaries and has a dislocation density below about 10⁴ cm⁻². In one embodiment, the dislocation density of the crystal structure is below 10³ cm⁻², and in another embodiment, below 100 cm⁻². Moreover, in one embodiment the GaN wafers have a (0001) crystallographic orientation, in one embodiment with a Ga-terminated (0001) face and an N-terminated (0001̅) face for superior deposition of photodetector device structures.

In the exemplary embodiment shown in Figure 26, the photodetector 100 has a metal-semiconductor-metal (MSM) structure having at least one active layer 104. The at least one active layer 104 is an insulating layer disposed on a surface of substrate 102 and, in one embodiment, comprises Ga_{1-*x-y*}AL*ₓ*In_{y}N_{1-*z*-*w*}P*_{z}*As*_{w}*, wherein 0 ≤ *x*, *y, z, w* ≤ 1, 0 ≤ *x* + *y* ≤ 1, and 0 ≤ *z* + *w* ≤ 1. In another embodiment, the at least one active layer 104 comprises Ga_{1-*x*}Al*ₓ*N, wherein 0 ≤ *x* ≤ 1. The insulating layer 104 can be doped or undoped, and typically has a thickness in the range between about 1 nm to about 10 microns. Additionally, insulating layer 104 typically has a carrier concentration of up to about 10¹⁸ cm⁻³; Substrate 102 comprises either n-doped or insulating gallium nitride. Conductive contact structure 106, comprising a plurality of Schottky contacts 108, is disposed on a surface 110 of insulating layer 104.

As shown in Figure 26, Schottky contacts 108 are interdigitated with respect to each other. In one example, the Schottky contacts 108 are made of nickel and gold. A portion of a respective Schottky contact 108 that contacts insulating layer 104 is preferably a contact layer (not shown) comprising at least one of nickel and a nickel-rich nickel-gold composition. Typically, the contact layer is contacted with at least one of gold and a gold-rich nickel-gold composition.

Metallic contacts are good electrical conductors, but have the disadvantage of having poor optical transparency, which decreases the light-collecting efficiency of the photodetector. This can be overcome by using conductive metal oxides such as, but not limited to, tin oxide and indium oxide instead of, or in combination with, the corresponding metal. Among the materials that may be used as Schottky or ohmic contacts are palladium, platinum, gold, aluminum, tin, indium, chromium, nickel, titanium, zinc, and oxides thereof. Additional materials that may be used as ohmic contacts include, but are not limited to, scandium, zirconium, tantalum, tungsten, copper, silver, hafnium, and rare earth metals.

In the embodiment shown in the Figure, Schottky contacts 108 may be sputtered onto surface 110 of insulating layer 104. Alternatively, Schottky contacts 108 may be deposited onto surface 110 of insulating layer 104 by electron beam evaporation. While sputtering and electron beam evaporation are discussed here, these processes are not to be considered limitations of the instant invention. In fact, any equivalent process can be used to deposit Schottky contacts 108 onto surface 110. In another embodiment, an n-doped layer 112 is disposed between substrate 102 and insulating layer 104.

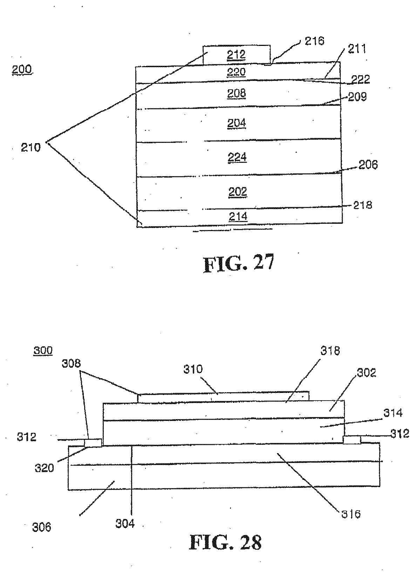

In the embodiment of Figure 27, the photodetector 200 has a P-i-N structure which includes a n-doped substrate 202, an insulating layer 204 disposed on a surface 206 of n-doped substrate 202 and a first p-doped layer 208 disposed on a surface 209 of insulating layer 204 opposite n-doped substrate 202, as shown in Figure 27. Insulating layer 204 and first p-doped layer 208 each have a nominal thickness in the range between about 1 nm to about 10 microns. Insulating layer 204 has a nominal carrier concentration of up to about 10¹⁸cm⁻³.

A conductive contact structure 210 typically comprises a first ohmic contact 212, typically made of nickel and gold. The first ohmic contact 212 is affixed to the first p-doped layer 208 and a second ohmic contact 214, typically made of titanium and aluminum, is affixed to the n-type substrate 202.

A portion of the first ohmic contact 212 that contacts first p-doped layer 208 is a contact layer 216 made of at least one of nickel and a nickel-rich nickel-gold composition. Typically, the contact layer 216 is contacted with an overlayer 217 comprising at least one of gold and a gold-rich nickel-gold composition. Among the materials that may be used as the first ohmic contact 212 to the first p-doped layer 208 are palladium, platinum, gold, aluminum, tin, indium, chromium, nickel, titanium, and oxides thereof. It is understood that these materials may be used to form an ohmic contact with any of the p-doped layers described herein.

In the embodiment shown in Figure 27, the first ohmic contact 212 may sputtered onto a surface 211 of the first p-doped layer 208. Alternatively, the first ohmic contact 212 may be deposited onto surface 211 of the first p-doped layer 208 by electron beam evaporation. While sputtering and electron beam evaporation are discussed here, these processes are not to be considered limitations of the instant invention. In fact, any equivalent process can be used to deposit first ohmic contact 212 onto surface 211.

In Figure 27, a portion of the second ohmic contact 214 that contacts n-type substrate 202 is preferably a contact layer 218 typically comprising a titanium-rich titanium-aluminum composition. Typically, the contact layer 218 is contacted with an overlayer 219 having an aluminum-rich titanium-aluminum composition. Materials that may be used as the second ohmic contact 214 that contacts n-type substrate 202 include, but are not limited to, aluminum, scandium, titanium, zirconium, tantalum, tungsten, nickel, copper, silver, gold, hafnium, and rare earth metals. It is understood that these materials may be used to form an ohmic contact with any of the n-doped layers described herein.

As shown, the second ohmic contact 214 may be sputtered onto n-type substrate 202. Alternatively, second ohmic contact 214 may be deposited onto the n-type substrate 202 by electron beam evaporation. While sputtering and electron beam evaporation are discussed here, these processes are not to be considered limitations of the instant invention. In fact, any equivalent process can be used to deposit second ohmic contact 214 onto n-type substrate 202.

In the embodiment shown in Figure 27, photodetector 200 may further comprise a second p-doped layer 220 comprising, for example, p-doped aluminum gallium nitride, disposed on a surface 211 of the first p-doped layer 208 opposite insulating layer 204. The photodetector may further comprise an n-doped layer 224, comprising, for example, n-doped gallium nitride, disposed between n-doped substrate 202 and insulating layer 204. In one embodiment of the invention shown in Figure 3, insulating layer 204, first p-doped layer 208, second p-doped layer 220, and n-doped layer 224 each comprise Ga_{1-*x*}Al*ₓ*N, wherein 0 ≤ *x* ≤ 1. In another embodiment, insulating layer 204, first p-doped layer 208, second p-doped layer 220, and n-doped layer 224 each comprise Ga_{1-*x-y*}Al*ₓ*In*_{y}*N_{1-*z-w*}P_{z}As*_{w}* wherein 0 ≤ *x, y, z*, *w* ≤ 1.0 ≤ *x*+*y* ≤ 1, and 0 ≤ *z*+*w* ≤ 1.

In the exemplary embodiment shown in Figure 28, the photodetector 300 is a Schottky barrier device in which at least one active layer 302 comprises an insulating layer disposed on a surface 304 of a substrate 306, which is typically either an n-doped or insulating GaN substrate, and a conductive contact structure 308 comprising at least one Schottky contact 310, typically made of nickel and gold, affixed to insulating layer 302 and at least one ohmic contact 312, typically made of titanium and aluminum, is affixed to substrate 306. The insulating layer 302 has a nominal carrier concentration of up to about 10¹⁸cm⁻³.

In the embodiment shown in Figure 28, photodetector 300 may further comprise a first n-doped layer 314 disposed between substrate 306 and insulating layer 302. The first n-doped layer 314 has a nominal thickness in the range between about 1 nm to about 10 microns. In another embodiment, photodetector 300 may further comprise a second n-doped layer 316, typically comprising n-doped gallium nitride, that is disposed between substrate 306 and first n-doped layer 314. In this embodiment, the substrate 306 is typically an insulating GaN substrate. The second n-doped layer 316 contacts at least one ohmic contact 312. Second n-doped layer 316 has a nominal thickness in the range between about 1 nm to about 10 microns. In one embodiment of the invention shown, active (which, in this example, is insulating) layer 302, first n-doped layer 314, and second n-doped layer 316 each comprise Ga_{1-*x*}Al*ₓ*N, wherein 0 ≤ *x* ≤ 1. In another embodiment, active (which, in this example, is insulating) layer 302, first n-doped layer 314, and second n-doped layer 316 each comprise Ga_{1-*x-y*}Al*ₓ*In*_{y}*N_{1-*z-w*}P_{z}As*_{w}*, wherein 0 ≤ *x, y, z, w ≤* 1,0 *≤ x*+*y ≤* 1*,* and 0 ≤ *z*+*w* ≤ 1.

A portion of at least one Schottky contact 310 that contacts insulating layer 302 is preferably a contact layer 318 that comprises at least one of nickel and a nickel-rich nickel-gold composition. Typically, contact layer 318 is contacted with an overlayer 319 comprising at least one of gold and a gold-rich nickel-gold composition. At least one Schottky contact 310 has a nominal thickness in the range between about 0.001 microns to about 10 microns.

In Figure 28, the at least one Schottky contact 310 may be sputtered onto insulating layer 302. Alternatively, Schottky contact 310 may be deposited onto insulating layer 302 by electron beam evaporation. While sputtering and electron beam evaporation are discussed here, these processes are not to be considered limitations of the instant invention. In fact, any equivalent process can be used to deposit Schottky contact 310 onto insulating layer 302.

A portion of at least one ohmic contact 312 that contacts substrate 306 is a contact layer 320, preferably made of a titanium-rich titanium-aluminum composition. Typically, contact layer 320 is contacted with an overlayer 321 having an aluminum-rich titanium-aluminum composition.

In one embodiment, at least one ohmic contact 312 is sputtered onto substrate 306. Alternatively, ohmic contacts 312 are deposited onto substrate 306 by electron beam evaporation. While sputtering and electron beam evaporation are discussed here, these processes are not to be considered limitations of the instant invention. In fact, any equivalent process can be used to deposit ohmic contacts 312 onto substrate 306.

In one embodiment, at least one of substrate 102, 202, 306 and at least one of active layer 104, 204, 302 further comprise at least one n-dopant, typically selected from the group consisting of silicon, germanium, and oxygen. The n-dopant is typically epitaxially deposited in at least one of substrate 102, 202, 306 and at least one active layer 104, 204, 302. Alternatively, the n-dopant is implanted in at least one of substrate 102, 202, 306 and at least one active layer 104, 204, 302.

In another embodiment of the present invention, at least one of substrate 102, 202, 306 and at least one of active layer 104, 204, 302 further comprise at least one p-dopant, typically selected from the group consisting of magnesium, calcium, and beryllium. The p-dopant is typically epitaxially deposited in at least one of substrate 102, 202, 306 and at least one active layer 104, 204, 302. Alternatively, p-dopant is implanted in at least one of substrate 102, 202, 306 and at least one active layer 104, 204, 302.

In one embodiment, photodetector 100, 200, 300 is used in a flame detector adapted to detect a flame in a combustion chamber (not shown). The stoichiometry of each of the active layers 104, 204, 302 determines the sensitivity of respective photodetector 100, 200, 300 to particular wavelengths of electromagnetic radiation. More specifically, the relative amounts of the different metals in the active layer - for example, the relative amounts of aluminum and gallium in Ga_{1-*x*}Al*ₓ*N - determine the wavelength range to which the photodetector 100, 200, 300 will respond. Photodetector 100, 200, 300 can thus be tuned to detect specific wavelengths of radiation by depositing an active layer 104, 204, 302 having the appropriate composition. A combination of at least two flame detectors may be used to monitor two different emission ranges for flame temperature determination. In another embodiment, substrate 102, 202, 306 is a gallium nitride substrate comprising a single crystal gallium nitride wafer substantially free of tilt boundaries and having a nominal dislocation density of less than about 10⁴cm-². Gallium nitride substrate 102, 202, 306 has a nominal resistivity of at least about 10⁵Ω-cm. Alternatively, the gallium nitride substrate 102, 202, 306 has a resistivity of less than about 10Ω-cm. Gallium nitride substrate 102, 202, 306 preferably has a nominal dislocation density of less than about 10³cm⁻², and even more preferably has a nominal dislocation density of less than about 100cm⁻².

The gallium nitride wafer has a nominal diameter in the range between about 3mm to about 150 mm. In one embodiment, the gallium nitride wafer has a diameter in the range between about 12 mm and about 150 mm. In yet another embodiment, the gallium nitride wafer has a diameter in the range between about 20 mm to about 150 mm. In one embodiment, the gallium nitride wafer has a (0001) crystallographic orientation.

In one embodiment of the invention, the photodetector is a quantum well infrared photodetector (QWIP). Quantum well infrared photodetectors are used for detecting infrared (IR) light for detectors and sensors and for imaging applications, being sensitive to 6-25 µm infrared radiation. The QWIP structure comprises multiple quantum well layers, where the compositions and thicknesses of each Ga_{1-*x-y*}Al*ₓ*In*_{y}*N_{1-*z*-*w*}P_{z}As*_{w}*, wherein 0 ≤ *x, y, z, w* ≤ 1,0 ≤ *x+y* ≤ 1, and 0 ≤ *z* + *w* ≤ 1, well and barrier layer are chosen such that there is one ground state and at most one excited state in each well and the excitation energy corresponds to the photon energy of interest.

In yet another embodiment of the invention, the photodetector is a quantum dot infrared photodetector (QDIP), which comprises multiple layers of semiconductor materials, for example, from bottom to top, a bottom contact layer which serves as a collector or an emitter which will may be doped to provide carriers and for conductivity, a first barrier layer which can be doped continuously or modulation doped as shown to provide carriers and for conductivity, and at least a first quantum dot layer. On the GaN substrate of the invention, which is substantially free of tilt boundaries and has a dislocation density less than 10⁴ cm⁻², the quantum dot material and barrier material each comprise Ga_{1-*x-y*}Al*ₓ*In*_{y}*N_{1-*z-w*}P_{z}As*_{w}*, wherein 0 ≤ *x, y, z, w* ≤ 1,0 ≤ *x*+*y* ≤ 1, and 0 ≤ *z* + *w* ≤ 1, where the bandgap of the barrier material exceeds that of the quantum dot material.

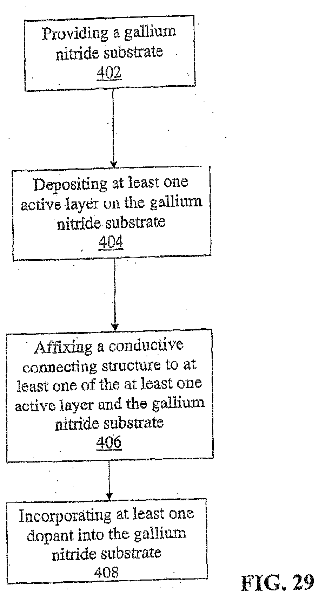

Figure 29 illustrates a method 400 of making a photodetector 100, 200, 300, wherein the photodetector 100, 200, 300 comprises a gallium nitride substrate 102, 202, 306, at least one active layer 104, 204, 302 disposed on gallium nitride substrate 102, 202, 306 and at least one conductive contact structure 106, 210, 308 affixed to at least one of gallium nitride substrate 102, 202, 306 and active layer 104, 204, 302.

Method 400 comprises the steps of: 402 providing a gallium nitride substrate (102, 202, 306); 404 depositing at least one active layer (104, 204, 302) on the gallium nitride substrate (102, 202, 306); and 406 affixing a conductive connecting structure (106, 210, 308) to at least one of the at least one active layer (104, 204, 302) and the gallium nitride substrate (102, 202, 306).

Step 404, which comprises depositing at least one active layer (104, 204, 302) on the gallium nitride substrate (102, 202, 306), typically comprises depositing at least one active layer (104, 204, 302) by metal organic vapor phase epitaxy or, alternatively, by molecular beam epitaxy.

Step 406, which comprises affixing a conductive connecting structure 106, 210, 308 to at least one of the active layer (104, 204, 302) and gallium nitride substrate (102, 202, 306) may include either sputter-depositing a metallic layer on at least one of the at least one active layer (104, 204, 302) and the gallium nitride substrate (102, 202, 306) or, alternatively, electron beam evaporating a metallic layer on at least one of the at least one active layer (104, 204, 302) and the gallium nitride substrate (102, 202, 306).

In one embodiment, method 400 further includes the step 408 of incorporating at least one dopant into the gallium nitride substrate (102, 202, 306).

Step 408, which comprises incorporating at least one dopant into the gallium nitride substrate (102, 202, 306), may comprise epitaxially depositing a doped layer on the gallium nitride substrate (102, 202, 306), preferably by metal organic vapor phase epitaxy. Alternatively, the dopant may be incorporated into the gallium nitride substrate (102, 202, 306) by implanting the dopant in the gallium nitride substrate (102, 202, 306).

It should be noted that modifications and alterations are within the scope of the invention, for example, while the detailed descriptions of the device embodiments contain the inventive substrate, for some applications it may be advantageous to remove the substrate after deposition of one or more epitaxial layers. Removal of the substrate may be desirable, for example, in an ultraviolet LED with an emission wavelength below 365 nm so as to avoid light absorption by the substrate, or in a high power device so that the active layer may be placed in closer proximity to a heat sink.

Removal of the substrate may be achieved by lapping, polishing, ion milling, laser-induced decomposition, or by other methods that are known in the art. Even after removal of the substrates, the device will be characterized by one or more epitaxial layers that have a dislocation density below 10⁴ cm⁻² and are substantially free of tilt boundaries.

EXAMPLES. The following Comparative Examples (Comparative Examples 1-3) are provided for comparison to the Examples (Examples 1-4).

The Comparative Examples do not necessarily constitute prior art to the present invention, but are provided for comparison purposes.

Comparative Example 1. 0.1 g of NH₄F mineralizer was placed in the bottom of a 0.5 inch diameter silver capsule. A baffle with 5.0% open area was placed in the middle portion of the capsule, and 0.31 g of polycrystalline GaN source material was placed in the upper half of the capsule: The capsule was then enclosed within a filler/sealing assembly together with a 0.583 inch diameter steel ring. The capsule and filler/sealing assembly were transferred to a gas manifold and filled with 0.99 g of ammonia. Next, a plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke high pressure high temperature (HPHT) apparatus. The cell was heated to approximately 700°C and held at this temperature for 55 hours, with a temperature gradient of approximately 85°C. The cell was then cooled and removed from the press.

Upon opening the capsule after venting of the ammonia, numerous spontaneously-nucleated crystals were observed at the bottom of the capsule. One crystal approximately 0.36 mm in diameter was selected at random and etched in 10% HCl in Ar at 625 °C for 30 min. No etch pits were observed. The area of the exposed c-face was approximately 5.3×10⁻⁴ cm², indicating that the etch pit density was less than (1/(5.3×10⁻⁴ cm²)) or 1900 cm⁻². By contrast, the identical etching treatment was applied to a 200 µm-thick piece of GaN grown by hydride/halide vapor phase epitaxy (HVPE), and an etch pit density of 2×10⁷ cm⁻² was observed on the Ga face.

Comparative Example 2. Three seeds, weighing 3-4 mg each, were placed in the bottom of a 0.5 inch diameter silver capsule along with 0.10 g of NH₄F mineralizer. A baffle with 5.0% open area was placed in the middle portion of the capsule, and 0.34 g of polycrystalline GaN source material was placed in the upper half of the capsule. The capsule was then enclosed within a filler/sealing assembly together with a 0.675 inch diameter steel ring. The capsule and filler/sealing assembly were transferred to the gas manifold and filled with 1.03 g of ammonia. Next, the plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke HPHT apparatus. The cell was heated at about 15 °C/min to approximately 500 °C, then at 0.046 °C/min to 700°C, and held at the latter temperature for 6 hours, with a temperature gradient of approximately 28°C. The cell was then cooled and removed from the press.

Upon opening the capsule after venting of the ammonia, numerous spontaneously-nucleated crystals were observed at the bottom of the capsule and, despite the very slow heating rate, very little growth on the seeds occurred, relative to growth on spontaneously-nucleated crystals.

Comparative Example 3 A GaN seed, weighing 10.4 mg, was placed in the bottom of a 0.5 inch diameter silver capsule along with 0.04 g of NH₄F mineralizer. A baffle with 5.0% open area was placed in the middle portion of the capsule, and 0.74 g of polycrystalline GaN source material was placed in the upper half of the capsule. The capsule was then enclosed within a filler/sealing assembly together with a 0.675 inch diameter steel ring. The capsule and filler/sealing assembly were transferred to the gas manifold and filled with 1.14 g of ammonia. Next, the plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke HPHT apparatus. The cell was heated at about 15 °C/min to approximately 500 °C, then at 0.05 °C/min to 680°C, and held at the latter temperature for 53 hours, with a temperature gradient of approximately 70°C. The cell was then cooled and removed from the press.

Upon opening the capsule after venting of the ammonia, numerous spontaneously-nucleated crystals were observed at the bottom of the capsule despite the very slow heating rate. The seed did grow significantly, to a weight of 41.7 mg and a diameter of about 2 mm. However, the weight of spontaneously-nucleated crystals was more than 10× the weight increase of the seed.

Example 1. A small hole was drilled by a high-power laser through a GaN seed crystal weighing 19.7 mg. The seed was hung by a 0.13-mm silver wire from a silver baffle with a 35% open area and placed in the lower half of a 0.5 inch diameter silver capsule along with 0.10 g of NH₄F mineralizer. 0.74 g of polycrystalline GaN source material was placed in the upper half of the capsule. The capsule was then enclosed within a filler/sealing assembly together with a 0.583 inch diameter steel ring. The capsule and filler/sealing assembly were transferred to a gas manifold and filled with 0.99 g of ammonia. Next, the plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke HPHT apparatus. The cell was heated at a rate of about 11 °C/min until the temperature of the bottom of the capsule was approximately 700 °C and the temperature of the top half of the capsule was approximately 660 °C, as measured by type K thermocouples. The current through the top half of the heater was then increased until the temperature gradient δ*T* decreased to zero. After holding at δ*T* = 0 for 1 hour, the temperature of the top half of the capsule was decreased at 5 °C/hr until *δT* increased to approximately 35 °C, and the temperatures were held at these values for 78 hr. The cell was then cooled and removed from the press.

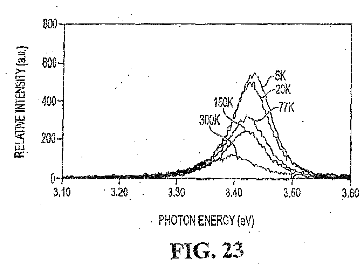

Upon opening the capsule after venting of the ammonia, the seed weight was observed to have increased to 33.4 mg. The crystal was characterized by photoluminescence, using a 266 nm excitation (frequency-quadrupled YAG). The spectra at several temperatures are as illustrated in Fig. 23. Specifically the crystal sample was characterized by photoluminescence at temperatures of 5K, 20K, 77K and 300K. At all temperatures in the range of 5K-300K, the luminescence peak occurs between 3.38 and 3.45 eV.

Example 2 A GaN seed crystal weighing 12.6 mg, obtained from a previous run, was hung through a laser-drilled hole by a 0.13-mm silver wire from a silver baffle with a 35% open area and placed in the lower half of a 0.5 inch diameter silver capsule. 0.10 g of NH₄F mineralizer and 1.09 g of polycrystalline GaN source material were placed in the upper half of the capsule. The capsule was then enclosed within a filler/sealing assembly together with a 0.583 inch diameter steel ring. The capsule and filler/sealing assembly were transferred to the gas manifold and filled with 0.95 g of ammonia. Next, the plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke HPHT apparatus. The cell was heated at a rate of about 11 °C/min until the temperature of the bottom of the capsule was approximately 700 °C and the temperature of the top half of the capsule was approximately 640 °C, as measured by type K thermocouples. The current through the top half of the heater was then increased until the temperature gradient δ*T* decreased to zero. After holding at δ*T* = 0 for 1 hour, the temperature of the top half of the capsule was decreased at 5 °C/hr until δ*T* increased to approximately 50 °C, and the temperatures were held at these values for 98 hr. The cell was then cooled and removed from the press.

Upon opening the capsule after venting of the ammonia, the seed had grown to a weight of 24.3 mg. The crystal was then etched in 10% HCl in Ar at 625 °C for 30 min. Some etch pits were observed on the c-face above the region of the seed, with an etch pit density of about 10⁶ cm⁻². However, the areas that grew laterally with respect to the seed were free of etch pits. The area of newly laterally-grown GaN was approximately 3.2×10⁻² cm², indicating that the etch pit density was less than (1/3.2×10⁻² cm²) or 32 cm⁻².

Example 3 Two GaN seeds, weighing 48.4 mg and 36.6 mg and obtained from a previous run, were hung through laser-drilled holes by a 0.13-mm silver wire from a silver baffle with a 35% open area and placed in the lower half of a 0.5 inch diameter silver capsule. 0.10 g of NH₄F mineralizer and 1.03 g of polycrystalline GaN source material were placed in the upper half of the capsule. The capsule was then enclosed within a filler/sealing assembly together with a 0.583 inch diameter steel ring. The capsule and filler/sealing assembly were transferred to the gas manifold and filled with 1.08 g of ammonia. Next, the plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke HPHT apparatus. The cell was heated at about 11 °C/min until the temperature of the bottom of the capsule was approximately 700 °C and the temperature of the top half of the capsule was approximately 642 °C, as measured by type K thermocouples. The current through the top half of the heater was then increased until the temperature gradient δ*T* decreased to zero. After holding at δ*T* = 0 for 1 hour, the temperature of the top half of the capsule was decreased at 5 °C/hr until δ*T* increased to approximately 30 °C, and the temperatures were held at these values for 100 hr. The cell was then cooled and removed from the press.

Upon opening the capsule after venting of the ammonia, the seeds had grown to a weight of 219.8 mg. A piece broke off from the smaller of the two crystals and was selected for analysis. An optical transmission spectrum of the crystal was measured using a Cary 500i spectrometer. The transmission was greater than 60% for wavelengths ranging from red (700 cm⁻¹) to blue (465 cm⁻¹).

Based on the index of refraction for GaN [G Yu et al., Applied Physics Letters 70, 3209 (1997)] and the thickness of the crystal, 0.206 mm, the optical absorption coefficient was less than 5 cm over the same wavelength range. The crystal was determined to have n-type electrical conductivity by means of a hot-point probe measurement. The crystal was then etched in 10% HCl in Ar at 625 °C for 30 min. The entire crystal was free of etch pits. The area of the c-face of the crystal was approximately 4.4×10⁻² cm², indicating that the etch pit density was less than (1/4.4×10⁻² cm²) or 23 cm⁻².

Example 4 A GaN seed weighing 25.3 mg, obtained from a previous run, was hung through a laser-drilled hole by a 0.13-mm silver wire from a silver baffle with a 35% open area and placed in the lower half of a 0.5 inch diameter silver capsule. 0.10 g of NH₄F mineralizer and 0.98 g of polycrystalline GaN source material were placed in the upper half of the capsule. The capsule was then enclosed within a filler/sealing assembly together with a 0.583 inch diameter steel ring. The capsule and filler/sealing assembly were transferred to the gas manifold and filled with 1.07 g of ammonia. Next, the plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke HPHT apparatus. The cell was heated at about 11 °C/min until the temperature of the bottom of the capsule was approximately 700 °C and the temperature of the top half of the capsule was approximately 648 °C, as measured by type K thermocouples. The current through the top half of the heater was then increased until the temperature gradient δ*T* decreased to 3 °C. After holding at δ*T* = 3 °C for 1 hour, the temperature of the top half of the capsule was decreased at 5 °C/hr until δ*T* increased to approximately 30 °C, then decreased further at 2.5 °C/hr until δ*T* increased to approximately 60 °C and the temperatures were held at these values for 20 hr. The cell was then cooled and removed from the press.

Upon opening the capsule after venting of the ammonia, the seed had grown to a weight of 40.2 mg. The crystal was then etched in 50% HNO₃ for 30 min. A row of etch pits was observed on the c-face above the interface between the seed and new, laterally-grown material. However, the remaining areas of newly-grown GaN were free of etch pits. The area of pit-free newly grown GaN was approximately 6.9×10⁻² cm² , indicating that the etch pit density was less than (1/6.9×10⁻² cm²) or 14 cm⁻².

Example 5 A GaN seed weighing 13.5 mg, grown by HVPE, was hung through a laser-drilled hole by a 0.13-mm silver wire from a silver baffle with a 35% open area and placed in the lower half of a 0.5 inch diameter silver capsule. 0.10 g of NH₄F mineralizer, 0.03 g of CoF₂; and 0.30 g of polycrystalline GaN source material were placed in the upper half of the capsule. The capsule was then enclosed within, a filler/sealing assembly together with a 0.583 inch diameter steel ring. The capsule and filler/sealing assembly were transferred to the gas manifold and filled with 1.01 g of ammonia. Next, the plug was inserted into the open top end of the capsule, such that a cold weld was formed between the silver capsule and silver plug and the steel ring surrounded the plug and provided reinforcement. The capsule was then removed from the filler/sealing assembly and inserted in a zero stroke HPHT apparatus. The cell was heated at about 11 °C/min until the temperature of the bottom of the capsule was approximately 700 °C and the temperature of the top half of the capsule was approximately 634 °C, as measured by type K thermocouples, and the temperatures were held at these values for 10 hr. The cell was then cooled and removed from the press.

Upon opening the capsule after venting of the ammonia, the crystal grown crystal on seed weighed approximately 10.3 mg. The crystal showed clear evidence of growth, including facets and an increased thickness (0.7 mm) and was considerably darker in color than nominally undoped crystals. The decrease in the weight was due at least in part to etching of the seed during the initial portion of the profile, and the seed may additionally have undergone partial fragmentation to reduce the diameter. After washing, the Co-doped GaN crystal was sandwiched between two pieces of In foil that had been wet with a liquid Ga-In alloy, with an electrode area of approximately 0.02 cm². The electrical resistance across the crystal was found to be approximately 1,050 MΩ at room temperature with either polarity, corresponding to a resistivity of about 3x10⁸ Ω-cm. GaN with a resistivity greater than about 10⁵ Ω-cm is considered to be semi-insulating.

The growth rate of the GaN crystal is found to be substantially above 5 µm / hr.

The improved methods for forming GaN crystal material of the present invention enable the growth of larger high-quality GaN crystals. These improved GaN crystals enable the fabrication of better-performing electronic and optoelectronic devices, with improved efficiency, reliability, yields, high power performance, breakdown voltage, and reduced dark current and noise.

While only certain features of the invention have been illustrated and described herein, many modifications and changes will occur to those skilled in the art. It is, therefore, to be understood that the appended claims are intended to cover all such modifications and changes as fall within the true spirit of the invention.

The following items form part of the description:
1. A GaN single crystal having a maximum dimension of at least 2 millimeters, a dislocation density of less than 10⁴ cm⁻², substantially no tilt boundaries, and an oxygen impurity level of less than 10¹⁹ cm⁻³.
2. The GaN single crystal of item 1, wherein the GaN single crystal is grown from a single seed or nucleus.
3. The GaN single crystal of any of items 1-2, wherein the single crystal has an optical absorption coefficient below 100 cm⁻¹ at wavelengths between 465 and 700 nm.
4. The GaN single crystal of any of items 1-3, wherein the optical absorption coefficient is below 5 cm⁻¹ at wavelengths between 465 and 700 nm.
5. The GaN single crystal of any of items 1-4, having an infrared absorption peak near 3175 cm⁻¹ with an absorbance per unit thickness greater than about 0.01 cm⁻¹.
6. The GaN single crystal of any of items 1-5, containing between 0.04 and 1 ppm fluorine.
7. The GaN single crystal of any of items 1-6, wherein the single crystal comprises an n-type semiconductor material with an optical absorption coefficient below 100 cm⁻¹ at wavelengths between 465 and 700 nm.
8. The GaN single crystal of any of items 1-7, wherein the single crystal has a photoluminescence spectrum peaking at a photon energy of between about 3.38 and about 3.41 eV at a crystal temperature of 300K.
9. The GaN single crystal of any of items 1-8, wherein said single crystal is one of n-type, semi-insulating type, and p-type.
10. The GaN single crystal of any of items 1-9, further comprising at least a dopant at a level of 10¹⁵ to 10²¹ cm⁻³.
11. The GaN single crystal of any of items 1-10, wherein said single crystal is magnetic and/or luminescent.
12. A method of forming a GaN single crystal comprising:
   (a) providing a nucleation center in a first region of a chamber having a first end;
   (b) providing a GaN source material in a second region of the chamber having a second end;
   (c) providing a GaN solvent and a mineralizer in the chamber;
   (d) pressurizing the chamber;
   (e) generating and holding a first temperature distribution such that the solvent is supersaturated in the first region of the chamber and such that there is a first temperature gradient between the first end and the second end such that GaN crystal grows on the nucleation center; and
   (f) generating a second temperature distribution in the chamber such that the solvent is supersaturated in the first region of the chamber and such that there is a second temperature gradient between the first end and the second end such that GaN crystal grows on the nucleation center, wherein the second temperature gradient is larger in magnitude than the first temperature gradient and the crystal growth rate is greater for the second temperature distribution than for the first temperature distribution.
13. The method of forming a GaN single crystal of item 12, wherein said GaN single crystal is grown at a rate of at least 5 µm/hr.
14. The method of forming a GaN single crystal of any of items 12- 13, wherein said GaN single crystal growth rate is at least 10 µm/hr.
15. The method of forming a GaN single crystal of any of items 12- 14, wherein the GaN single crystal formed has a maximum dimension of at least 2 millimeters, a dislocation density of less than 10⁴ cm⁻² , and substantially no tilt boundaries.
16. The method of forming a GaN single crystal of any of items 12- 15,
   wherein the seed crystal is hung by a wire;
   the first region is kept separate from the second region by a baffle having between 1% and 50% open area;
   the solvent comprises at least one of ammonia, hydrazine, methylamine, ethylenediamine and melamine; and
   the source material comprises at least one of single crystal GaN, amorphous GaN, polycrystalline GaN, and a GaN precursor.
17. The method of forming a GaN single crystal of any of items 12- 16, further comprising the step of providing a mineralizer in the chamber, and
   wherein said mineralizer comprises at least comprise at least one of: alkali and alkaline-earth nitrides, amides, urea and related compounds, ammonium salts, rare earth salts, halide salts, sulfide salts, nitrate salts, azide salts, compounds formed by chemical reaction of Ga and/or GaN with at least one of the above, and mixtures thereof.
18. The method of forming a GaN single crystal of any of items 12- 17, further comprising providing a dopant source for doping of n-type, semi-insulating, or p-type GaN crystals, and wherein the dopant source comprises at least one dopant selected from H, Be, C, O, Si, Ge, Be, Mg, Zn, Ca, Sc, Ti, V, Cr, Mn, Fe, Co, Ni, Cu, Zr, Hf, and a rare earth metal.
19. The method of forming a GaN singly crystal of any of items 12- 18, wherein the dopant is at a level of 10¹⁵ to 10²¹ cm⁻³.
20. A GaN single crystal formed by the method of any of items 12- 19.
21. A semiconductor structure comprising the GaN single crystal of any of items 1-11 and item 20, and at least one semiconductor layer or partial layer disposed on said GaN single crystal, and wherein said semiconductor layer or partial layer is at least one of :
   a) AlₓIn_{y}Ga_{1-x-y}N where 0≤x≤1, 0≤y≤1 and 0≤x+y≤1 ; and
   b) Ga_{1-x-y} AlₓIn_{y}N_{1-z-w} P_{z}As_{w}, wherein 0 ≤ x, y, z, w ≤ 1, 0≤x + y≤1, and 0≤z + w ≤ 1
   c) AlₓGa₁₋ₓN where 0 ≤x≤1;
   d) In_{y}Ga_{1-y}N where 0≤y≤1.
22. The semiconductor structure of item 21, wherein the single crystal is one of a wafer, a boule and an ingot.
23. An electronic device containing the GaN single crystal of any of items 1-11 and item 20, wherein said device is selected from the group consisting of a light emitting diode, a laser diode, a photodetector, an avalanche photodiode, a cascode switch, a transistor, a rectifier and a thyristor, one of a transistor, a rectifier, a Schottky rectifier, a thyristor high-electron mobility transistor (HEMT), a metal semiconductor field effect transistor (MESFET), a metal oxide field effect transistor (MOSFET), a power metal oxide semiconductor field effect transistor (power MOSFET), a power metal insulator semiconductor field effect transistor (power MISFET), a bipolar junction transistor (BJT), a metal insulator field effect transistor (MISFET), a heterojunction bipolar transistor (HBT), a power insulated gate bipolar transistor (power IGBT), a power vertical junction field effect transistor (power vertical JFET), an inner subband emitter, a quantum well infrared photodetector (QWIP), a quantum dot infrared photodetectors (QDIP), and combinations thereof.
24. An electronic device comprising at least one epitaxial semiconductor active region disposed on a single crystal substrate comprised of GaN, the substrate having a maximum dimension of at least 2 millimeters, a dislocation density of less than 10⁴ cm⁻², substantially no tilt boundaries, and an oxygen impurity level of less than 10¹⁹ cm⁻³.
25. The electronic device of item 24, wherein said device has a lateral dimension of at least about 100 µm.
26. The electronic device of any of items 24-25, wherein said substrate has at least one of :
   an absorption coefficient below about 5 cm⁻¹ at wavelengths between 700 and 465 nm;
   a carrier mobility above about 100 cm²/V-s;
   a strain below about 0.005%;
   a thickness between about 0.05 and 5 mm;
   a carrier concentration below 1 x 10¹⁹ cm⁻³;
   an optical absorption coefficient below about 100 cm⁻¹ at wavelengths between 700 and 465 nm fluorine, at a concentration between 0.04 and 1 ppm ; and
   at least one infrared absorption peak in the range of 3050 to 3300 cm⁻¹, with an absorbance per unit thickness between 0.01 and 200 cm⁻¹.
27. The electronic device of any of items 24-26, wherein said substrate is one of:
   an n-type substrate with an electrical resistivity below about 10 Ω-cm;
   a p-type substrate with an electrical resistivity below about 100 Ω-cm, and
   a semi-insulating GaN with an electrical resistivity above about 10⁵ Ω-cm.
28. The electronic device of any of items 24-27, wherein said semiconductor active region emits light in the ultraviolet to red range of the electromagnetic spectrum.
29. The electronic device of any of items 24-28, wherein said semiconductor active region is one of the formula:
   Al_{w}InₓGa_{1-w-x}N where 0≤w, x, w+x<1;
   Al_{c}In_{d}Ga_{1-c-d}N/ AlₑIn_{f}Ga_{1-e-f}N where 0 ≤c, d, e, f, c+d, e+f≤1;
   In_{d}Ga_{1-d} N/ In_{f}Ga_{1-f}N, where 0≤d≤f.
30. The electronic device of any of items 24-29, wherein said semiconductor active region is disposed directly on said substrate.
31. The electronic device of any of items 24-30, wherein said semiconductor active region comprises a single doped layer having a thickness between about 2 and 500 nm.
32. The electronic device of any of items 24-31, wherein
   said semiconductor active region comprises a plurality of alternating layers forming a multiple quantum well with a first alternating layer having a composition of Al_{c}In_{d}Ga_{1-c-d}N and a second alternating layer having a composition of AlₑIn_{f}Ga_{1-e-f}N, wherein 0 ≤c, d, e, f, c+d, e+f≤1; and
   each alternating layer has a thickness between 0.5 and 50 nm.
33. The electronic device of any of items 24-32, wherein
   said semiconductor active region comprises a plurality of layers having a composition of Al_{c}In_{d}Ga_{1-c-d}N, wherein 0 ≤c, d, c+d,< 1 ; and
   each active layer is separated by a heavily-doped p⁺/n⁺ tunnel junction.
34. The electronic device of any of items 24-33, further comprises:
   a first cladding layer comprising p-Al_{y}In_{z}Ga_{1-y-z}N and having a larger band gap than the active layer, wherein 0 ≤y, z, y+z < 1;
   a second cladding layer comprising one of n-GaN and n-AlᵤInᵥGa₁₋ᵤ₋ᵥN and having a larger band gap than the active layer, wherein 0 ≤ u, v, u+v < 1.
35. The electronic device of any of items 24-34, wherein said semiconductor active region comprises a buffer layer disposed over the substrate.
36. The electronic device of any of items 24-35, wherein the at least semiconductor active region further comprises a light-guiding layer.
37. The electronic device of any of items 24-36, wherein the at least one semiconductor active region comprises a contact layer disposed over the substrate.
38. The electronic device of any of items 24-37, wherein the at least one semiconductor active region comprises a channel layer disposed over the substrate.
39. The electronic device of any of items 24-38, wherein the at least one semiconductor active region comprises a subcollector layer disposed over the substrate.
40. The electronic device of any of items 24-39, wherein the at least one semiconductor active region comprises:
   a voltage blocking layer;
   a p-type channel layer disposed over the voltage blocking layer; and
   a n-type source layer disposed over the p-type channel layer.
41. The electronic device of any of items 24-40, wherein the at least one semiconductor layer further comprises:
   a heavily doped p-type base layer disposed over and in the voltage blocking layer;
   a lightly doped p-type base layer disposed over the heavily doped p-type base layer; and
   a n-type emitter layer disposed over and in the lightly doped p-type base layer.
42. The electronic device of any of items 24-41, wherein the at least one semiconductor layer comprises a voltage blocking layer.
43. The electronic device of any of items 24-42, wherein the at least one semiconductor layer further comprises:
   a source layer disposed over the voltage blocking layer; and
   a gate layer disposed over the voltage blocking layer and lateral to the source layer.
44. The electronic device of any of items 24-43, further comprising:
   a source contact disposed on the source layer; and
   a gate contact disposed on the gate layer.
45. The electronic device of any of items 24-44, wherein the electronic device is one of a light emitting diode, a laser diode, a photodetector, an avalanche photodiode, a transistor, a rectifier, a Schottky rectifier, a cascode switch, a thyristor high-electron mobility transistor (HEMT), a metal semiconductor field effect transistor (MESFET), a metal oxide field effect transistor (MOSFET), a power metal oxide semiconductor field effect transistor (power MOSFET), a power metal insulator semiconductor field effect transistor (power MISFET), a bipolar junction transistor (BJT), a metal insulator field effect transistor (MISFET), a heterojunction bipolar transistor (HBT), a power insulated gate bipolar transistor (power IGBT), a power vertical junction field effect transistor (power vertical JFET), and a high-electron mobility transistor (HEMT) array, and combinations thereof.
46. The electronic device of any of items 24-45, wherein the at least one semiconductor layer further comprises:
   a buried gate layer disposed in the voltage blocking layer; and
   a field stop layer disposed over and in the voltage blocking layer and lateral to the buried gate layer.
47. The electronic device of any of items 24-46, wherein the at least one semiconductor layer further comprises:
   a well layer disposed over the buried gate layer;
   a source layer disposed in the well layer and lateral to the field stop layer; and
   a drain layer disposed in the well layer and lateral to the field stop layer.
48. A method for the preparation of a homoepitaxial gallium nitride based electronic device, the method comprising the step of forming at least one semiconductor active layer on a substrate comprised of GaN, and wherein the substrate has a maximum dimension of at least 2 millimeters, a dislocation density of less than 10⁴ cm⁻², substantially no tilt boundaries, and an oxygen impurity level of less than 10¹⁹ cm⁻³.
49. The method of item 48, wherein the forming step comprises at least one of molecular beam epitaxy (MBE), hydride vapor phase epitaxy (HVPE), and metalorganic vapor-phase epitaxy (MOVPE).
50. The method of any of items 48-49, wherein the forming step comprises providing at least one organometallic precursor selected from trimethylgallium, Ga(CH₃)₃,trimethylaluminum, Al(CH₃)₃, and trimethylindium, In(CH₃)₃.
51. The method of any of items 48-50, further comprising the step of forming electrical contacts on the at least one semiconductor active layer, and wherein said electrical contacts comprise at least a material selected from the group consisting of Ni, Ni/Au, Ti/Al, Pd, Pt, Au, Ag, Cu, Al, Sn, In, Cr, Ti, Sc, Zr, Ta, W, Ni, Hf, Mo, P, As, a rare earth metal, combinations and oxides thereof.
52. The method of any of items 48-52, further comprising the deposition of cladding layers comprising at least one of n-GaN, n-AlᵤInᵥGa₁₋ᵤ₋ᵥN, p- Al_{y}In_{Z}Ga_{1-y-z}N, p-GaN, and combinations thereof, wherein 0 ≤ u, v, y, z, u+v, y+z < 1, and wherein the band gap of the active layer is less than the band gap of the cladding layers.
53. A device comprising at least one homoepitaxial light emitting diode, the homoepitaxial light emitting diode comprising:
   a. an n-electrode;
   b. a single crystal n-GaN substrate having a dislocation density less than about 10⁴ per cm², wherein said substrate is substantially free of crystallographic tilt boundaries and has an optical absorption coefficient below about 100 cm⁻¹ at wavelengths between 700 and 465 nm,
   c. an Al_{c}In_{d}Ga_{1-c-d}N / AlₑIn_{f}Ga_{1-e-f}N multiple quantum well layer;
   d. at least one cladding layer, the cladding layer comprising one of p-GaN and p- Al_{g}InₕGa_{1-g-h}N; and
   e. a p-electrode, and
   wherein 0 ≤ c, d, e, f, g, h, c+d, e+f ; g+h ≤ 1, and wherein the band gap of the active layer is less than that of the cladding layers.
54. A photodetector, said photodetector comprising:
   a. substrate comprising GaN, said GaN substrate having a dislocation density less than about 10⁴ per cm², wherein said substrate is substantially free of crystallographic tilt boundaries and has an optical absorption coefficient below about 100 cm⁻¹ at wavelengths between 700 and 465 nm,
      at least one active layer disposed on said substrate; and at least one conductive contact structure affixed to at least one of said substrate and said at least one active layer.
55. The photodetector of item 54, wherein said at least one active layer comprises one of Ga_{1-x-y} AlₓIn_{y}N_{1-z-w}P_{z}As_{w}, where 0≤x, y, z, w ≤1, 0 ≤ x + y≤ 1, and 0 ≤ z + *w* ≤ 1;
   Ga₁₋ₓ AlₓN, where 0≤ x ≤ 1.
56. The photodetector of any of items 54-55, wherein said conductive contact structure comprises at least one of a Schottky contact and an ohmic contact.
57. A method of forming a GaN single crystal comprising :
   (a) providing a nucleation center in a first: region of a chamber having a first end;
   (b) providing a GaN source material in a second region of the chamber having a second end;
   (c) providing a GaN solvent and a mineralizer in the chamber,
      wherein said solvent comprises ammonia and said mineralizer comprises at least one of HF, NH₄F, GaF₃, or their reaction products with Ga, GaN, NH₃ or with each other and is present at fluoride concentrations of 0.5 to 90 atomic % with respect to the NH₃ solvent;
   (d) pressurizing the chamber;
   (c) generating and holding a temperature distribution, such that the solvent is supersaturated in the first region of the chamber and such that there is a temperature gradient between the first end and the second end such that GaN crystal grows on the nucleation center.
58. A GaN-based semiconductor structure comprising at least one layer of AlₓIn_{y}Ga_{1-x-y} N, where 0≤x≤1, 0≤y≤1 and 0≤x+y≤1, wherein the structure has a dislocation density below 10⁴ cm⁻² and contains substantially no tilt boundaries.
59. A GaN-based. electronic device, wherein said device is selected from die group consisting of a light emitting diode, a laser diode, a. photodetector, an avalanche photodiode, a cascode switch, a transistor, a rectifier and a thyristor, one of a transistor, a rectifier, a Schottky rectifier, a thyristor high-electron mobility transistor (HEMT), a metal semiconductor field effect transistor (MESFET), a metal oxide field effect transistor (MOSFET), a power metal oxide semiconductor field effect transistor (power MOSFET), a power metal insulator semiconductor field effect transistor (power MISFET) a bipolar junction transistor (BJT), a metal insulator field effect transistor (MISFET), a heterojunction bipolar transistor (HBT), a power insulated gate bipolar transistor (power IGBT), a power vertical junction field effect transistor (power vertical JFET), an inner subband emitter, a quantum well infrared photodetector (QWIP), a quantum dot infrared photodetectors (QDIP), and combinations thereof, wherein the device comprises one or more AlₓIn_{y}Ga_{1-x-y}N epitaxial layers, where 0 ≤ x ≤ 1, 0 ≤ y ≤ 1 and 0 ≤ x+y≤ 1, having a dislocation density of less than 10⁴ cm⁻² and substantially no tilt boundaries.
60. The GaN-based structure of any of items 58 and 59, wherein said structure has a lateral dimension of at least about 100 µm.

## Claims

1. A crystal comprising:
a single crystal of GaN having a wurtzite structure; and
fluorine having a concentration of at least 0.04 ppm.

2. The crystal of claim 1, comprising at most 1 ppm fluorine.

3. The crystal according to claim 1, having an infrared absorption peak at 3175 cm⁻¹, with an absorbance per unit thickness of greater than 0.01 cm⁻¹.

4. The crystal according to claim 1, having an oxygen impurity level of less than 1×10¹⁹ cm⁻³.

5. The crystal according to claim 1, having an oxygen impurity level of less than 3×10¹⁸ cm⁻³.

6. The crystal according to claim 1, having a maximum dimension of at least 2 millimeters.

7. The crystal according to claim 1, having a dislocation density below 10⁶ cm⁻².

8. The crystal according to claim 5, having a dislocation density below 10⁴ cm⁻².

9. The crystal according to claim 1, wherein the single crystal is substantially free of tilt boundaries.

10. The crystal according to claim 1, wherein the single crystal comprises one of n- type and p-type semiconductor and is optically transparent, with an optical absorption coefficient below 100 cm⁻¹ at wavelengths between 700 and 465 nm.

11. The crystal of claim 9, wherein the optical absorption coefficient is below 5 cm⁻¹ at wavelengths between 465 and 700 nm.

12. The crystal according to claim 1, further comprising a dopant comprising one or more of Be, C, Mg, Si, H, Ca, Sc, Ti, V, Cr, Mn, Fe, Co, Ni, Cu, Zn, Ge, Zr, Hf, or a rare earth metal.

13. The crystal according to claim 11, wherein the dopant is present at a concentration in a range from 1×10¹⁶ per cubic centimeter to 1×10²¹ per cubic centimeter.

14. The crystal according to claim 1, wherein the crystal is magnetic,
is luminescent, or is both magnetic and luminescent.

15. The crystal according to claim 1, wherein the crystal is **characterized by** a photoluminescence spectrum which peaks at a photon energy of in a range of from about 3.38 to about 3.41 eV at a temperature of 300 K.

16. A crystal made from a process comprising:
providing a nucleation center in a first region of a chamber;
providing a gallium nitride source material in a second region of the chamber;
providing a solvent in the chamber, the solvent comprising nitrogen;
providing a mineralizer in the chamber, the mineralizer comprising fluorine; and
heating the chamber and performing ammonothermal growth of GaN on the nucleation center.

17. The crystal of claim 16, wherein the mineralizer comprises at least one of hydrogen fluoride, ammonium fluoride, gallium trifluoride, or a compound produced by a chemical reaction between at least one of hydrogen fluoride, ammonium fluoride, gallium trifluoride, and one or more of ammonia (NH₃), gallium, or gallium nitride.

18. The crystal of claim 16, wherein the process further comprises heating the chamber to a temperature of at least 550 degrees Celsius.

19. The crystal of claim 16, wherein the process further comprises
generating and holding a first temperature distribution such that the solvent is supersaturated in the first region of the chamber and such that there is a first temperature gradient between the nucleation center and the gallium nitride source material such that gallium nitride crystalline composition grows on the nucleation center; and
generating a second temperature distribution in the chamber such that the solvent is supersaturated in the first region of the chamber and such that there is a second temperature gradient between the nucleation center and the gallium nitride source material such that gallium nitride crystalline composition grows on the nucleation center, wherein the second temperature gradient is larger in magnitude than the first temperature gradient.

20. The crystal of claim 16, wherein the process further comprises:
generating and holding a first temperature distribution such that there is a first temperature gradient between the nucleation center and the gallium nitride source material; and
generating a second temperature distribution in the chamber such that the solvent is supersaturated in the first region of the chamber and such that there is a second temperature gradient between the nucleation center and the gallium nitride source material such that gallium nitride crystalline composition grows on the nucleation center, wherein the first temperature gradient is zero or opposite in sign from the second temperature gradient.
